(19) **Europäisches Patentamt / European Patent Office / Office européen des brevets**

(11) **EP 1 792 530 B1**

(12) **EUROPEAN PATENT SPECIFICATION**

(45) Date of publication and mention
of the grant of the patent:
**06.03.2013 Bulletin 2013/10**

(51) Int Cl.:
**H05K 7/20** (2006.01)

(21) Application number: **05792647.9**

(86) International application number:
**PCT/US2005/030967**

(22) Date of filing: **30.08.2005**

(87) International publication number:
**WO 2006/028846 (16.03.2006 Gazette 2006/11)**

(54) **CRAC UNIT CONTROL BASED ON RE-CIRCULATION INDEX**

STEUERUNG EINER CRAC-EINHEIT AUF DER BASIS DES RÜCKZIRKULATIONSINDEX

UNITE DE CONDITIONNEMENT D'AIR POUR SALLE INFORMATIQUE DONT LE
FONCTIONNEMENT EST BASE SUR L'INDICE DE RECIRCULATION

(84) Designated Contracting States:
**GB**

(30) Priority: **01.09.2004 US 931189**

(43) Date of publication of application:
**06.06.2007 Bulletin 2007/23**

(73) Proprietor: **HEWLETT-PACKARD DEVELOPMENT
COMPANY, L.P.
Houston, TX 77070 (US)**

(72) Inventors:
• **SHARMA, Ratnesh
Union City, CA 94587 (US)**

• **BASH, Cullen, E.
San Francisco, CA 94127 (US)**
• **PATEL, Chandrakant, D.
Fremont, CA 94536 (US)**

(74) Representative: **Frankhuizen, Jan
Hewlett-Packard Española S.L.
Legal Department
Avda. Graells, 501
08174 Sant Cugat del Vallès (ES)**

(56) References cited:
**EP-A- 0 741 269        WO-A-2004/107142
US-A1- 2003 067 745     US-A1- 2004 240 514**

**Description**

BACKGROUND OF THE INVENTION

A data center may be defined as a location, e.g., room, that houses computer systems arranged in a number of racks. A standard rack, e.g., electronics cabinet, is defined as an Electronics Industry Association (EIA) enclosure, 78 in. (2 meters) wide, 24 in. (0.61 meter) wide and 30 in (0.76 meter) deep. These racks are configured to house a number of computer systems, about forty (40) systems, with future configurations of racks being designed to accommodate 200 or more systems. The computer systems typically include a number of components, e.g., one or more of printed circuit boards (PCBs), mass storage devices, power supplies, processors, micro-controllers, semi-conductor devices, and the like, that may dissipate relatively significant amounts of heat during the operation of the respective components. For example, a typical computer system comprising multiple microprocessors may dissipate approximately 250 W of power. Thus, a rack containing forty (40) computer systems of this type may dissipate approximately 10 KW of power.

The power required to transfer the heat dissipated by the components in the racks to the cool air contained in the data center is generally equal to about 10 percent ofthe power needed to operate the components. However, the power required to remove the heat dissipated by a plurality of racks in a data center is generally equal to about 50 percent ofthe power needed to operate the components in the racks. The disparity in the amount of power required to dissipate the various heat loads between racks and data centers stems from, for example, the additional thermodynamic work needed in the data center to cool the air. In one respect, racks are typically cooled with fans that operate to move cooling fluid, for instance, air, conditioned air, etc., across the heat dissipating components; whereas, data centers often implement reverse power cycles to cool heated return air. The additional work required to achieve the temperature reduction, in addition to the work associated with moving the cooling fluid in the data center and the condenser, often add up to the 50 percent power requirement. As such, the cooling of data centers presents problems in addition to those faced with the cooling of the racks.

Conventional data centers are typically cooled by operation of one or more air conditioning units. For example, compressors of air conditioning units typically require a minimum of about thirty (30) percent of the required operating energy to sufficiently cool the data centers. The other components, for example, condensers, air movers (fans or blowers), typically consume an additional twenty (20) percent of the total operating energy. As an example, a high density data center with 100 racks, each rack having a maximum power dissipation of 10KW, generally requires 1 MW of cooling capacity. Air conditioning units with a capacity of 1 MW of heat removal generally requires a minimum of 300 KW input compressor power in addition to the power needed to drive the air moving devices, for instance, fans and blowers. Conventional data center air conditioning units do not vary their cooling fluid output based on the distributed needs of the data center. Instead, these air conditioning units generally operate at or near a maximum compressor power even when the heat load is reduced inside the data center.

The substantially continuous operation of the airconditioning units is generally designed to operate according to a worst-case scenario. For example, air conditioning systems are typically designed around the maximum capacity and redundancies are utilized so that the data center may remain on-line on a substantially continual basis. However, the computer systems in the data center typically utilize around 30-50% of the maximum cooling capacity. In this respect, conventional cooling systems often attempt to cool components that are not operating at a level which may cause their temperatures to exceed a predetermined temperature range. Consequently, conventional cooling systems often incur greater amounts of operating expenses than may be necessary to sufficiently cool the heat generating components contained in the racks of data centers.

Another factor that affects the efficiency of the cooling systems is the level of air recirculation present in the data center. That is, conventional cooling systems are not designed to reduce mixing of the cooling fluid with heated air. Thus, cooling fluid delivered to the racks generally mixes with air heated by the components thereby decreasing the efficiency of heat transfer from the components to the cooling fluid. In addition, heated air mixes with the cooling fluid thereby decreasing the temperature of the air returning to the air conditioning unit and thus decreasing the efficiency of the heat transfer at the air conditioning unit.

European Patent Application Publication No. 0,741,269 A2 discloses an Air Conditioning Method in a machine room having forced air-cooling equipment houses therein.

SUMMARY OF THE INVENTION

According to an embodiment, the present invention pertains to a method for controlling an air conditioning unit based on an index of performance designed to quantify re-circulation levels. In the method, an index of performance set point is determined and the index of performance for a first iteration is measured. In addition, it is determined whether the measured index of performance for the first iteration equals or exceeds the index of performance set point. The method also includes increasing a supply air temperature of the air conditioning unit in response to the measured index of performance for the first iteration equaling or exceeding the index of performance set point.

BRIEF DESCRIPTION OF THE DRAWINGS

Features of the present invention will become apparent to those skilled in the art from the following description with reference to the figures, in which:

FIG. 1A shows a simplified perspective view of a data center according to an embodiment of the invention;

FIG. 1B shows a simplified illustration of a side elevational view of the data center shown in FIG. 1A, according to an embodiment of the invention;

FIG. 1C is is a cross-sectional side view of an upper portion of a data center according to an embodiment of the invention;

FIG. 1D is a simplified schematic illustration of a data center having a lowered ceiling, according to an embodiment of the invention;

FIG. 2 is a block diagram for a cooling system according to an embodiment of the invention;

FIG. 3 illustrates a computer system according to an embodiment of the invention;

FIGS. 4A and 4B, collectively, illustrate a flow diagram of an operational mode of a cooling system according to an embodiment of the invention;

FIGS. 4C and 4D illustrate optional steps of the operational modes illustrated in FIGS. 4A and 4B, respectively, according to alternative embodiments of the invention;

FIG. 5 illustrates an exemplary flow diagram of an operational mode of a cooling system according to another embodiment of the invention;

FIG. 6 illustrates an exemplary flow diagram of an operational mode for designing and deploying a data center layout according to an embodiment of the invention;

FIG. 7 illustrates a flow diagram of an operational mode for a cooling system based substantially upon RHI values, according to an embodiment of the invention; and

FIGS. 8A and 8B, collectively illustrate a flow diagram of an operational mode for a cooling system based substantially upon RHI values, according to another embodiment of the invention.

DETAILED DESCRIPTION OF THE INVENTION

For simplicity and illustrative purposes, the present invention is described by referring mainly to an exemplary embodiment thereof. In the following description, numerous specific details are set forth in order to provide a thorough understanding of the present invention. It will be apparent however, to one of ordinary skill in the art, that the present invention may be practiced without limitation to these specific details. In other instances, well known methods and structures have not been described in detail so as not to unnecessarily obscure the present invention.

Throughout the present disclosure, reference is made to "cooling fluid" and "heated cooling fluid". For purposes of simplicity, "cooling fluid" may generally be defined as air that has been cooled by a cooling device, for instance, a computer room air conditioning (CRAC) unit. In addition, "heated cooling fluid" may generally be defined cooling fluid that has been heated, for instance, through receipt of heat from a heat generating/dissipating component. It should be readily apparent, however, that the terms "cooling fluid" are not intended to denote air that only contains cooled air and that "heated cooling fluid" only contains air that has been heated. Instead, embodiments of the invention may operate with air that contains a mixture of heated cooling fluid and cooling fluid. In addition, cooling fluid and heated cooling fluid may denote gases other than air, for instance, refrigerant and other types of gases known to be used in data centers by those of ordinary skill in the art.

Dimensionless, scalable parameters may be calculated according to various environmental conditions within a data center. These parameters may be implemented to control one or more of cooling fluid delivery to various locations of the data center, heated cooling fluid removal, and workload placement to provide efficient cooling of components in the data center. In one regard, cooling efficiency may be improved by reducing the amount of air re-circulation in the data center. That is, by reducing the re-circulation of heated cooling fluid with cooling fluid and vice versa, the potential of the cooling fluid to cool the components in the data center may be improved over known cooling systems. One result of the efficiency improvement attainable through operation of embodiments of the invention is that the amount of energy required to operate cooling systems in the data center may be reduced, thereby reducing associated operating costs.

The non-dimensional parameters may be used to determine a scalable "index of performance" for the data center cooling system. In addition, the index of performance may quantify the amount of re-circulation occurring at various locations of the data center. In this regard, the parameters are disclosed throughout the present disclosure as a supply heat index (SHI) and a return heat index (RHI). SHI and RHI may act as indicators of thermal management and energy efficiency of one or more components, a rack, a cluster of racks, or the data center as a whole.

SHI and RHI are calculated based upon temperatures measured at various locations throughout the data center. For example, the temperature of the cooling fluid supplied by a CRAC unit may be implemented to determine SHI and RHI. The temperature of the cooling fluid supplied by the CRAC unit may be considered as a reference temperature because the temperature of the cooling fluid at this point may substantially be controlled. In addition, the indices may be based upon the temperatures at various inlets and outlets. By way of example, the temperatures may be measured at the inlet of a supply vent, the inlet of a rack, the outlet of a rack, the inlet of a return vent, etc. As will be described in greater detail hereinbelow, the temperatures at these various locations are functions of the geometrical layout of the data center. In addition, the temperatures may be varied according to various manipulations of the supply vents as well as the rack inlets and outlets.

According to further embodiments of the invention, SHI and RHI may be computed through use of computional fluid dynamics modeling. This modeling may be performed to determine substantially optimized data center layouts. Thus, according to this embodimentofthe invention, the layout ofthe data center may be designed for substantially optimal cooling system energy use. This may entail positioning the racks into predetermined configurations with respect to the supply vents and the CRAC units. This may also entail use of racks having differing configurations for controlling airflow therethrough.

One or both of SHI and RHI may be implemented in operating data center cooling systems. For example, one or both of SHI and RHI may be used to control cooling fluid delivery to and/or heated cooling fluid removal from the racks. As another example, one or both of SHI and RHI may be used to determine substantially optimal computational load distribution among the racks. That is, based upon one or both of the SHI and RHI calculations, computing workload performed by one or more components, for instance, servers, computers, etc., located in the racks may be shared by one or more other components. Alternatively, the computing workload may be distributed among a lesser number of components.

As another example, RHI may be used to control provisioning of one or more CRAC units in the data center. RHI may be used to benchmark CRAC performance vis-à-vis the air delivery infrastructure of the data center. In general, CRAC units consume less energy when they operate at higher supply temperatures. A high RHI level generally indicates that a CRAC unit is receiving heated cooling fluid at a relatively high temperature and operating to deliver a certain level of cooling. Thus, when cooled cooling fluid re-circulates into the heated cooling fluid prior to being supplied into the CRAC units, the CRAC units consume greater amounts of energy to deliver the same level of cooling.

RHI setpoints may be used as bases for CRAC unit control. Thus, for instance, if the RHI level for a particular CRAC unit is above a predetermined RHI setpoint, the temperature of the cooling fluid supplied by the CRAC unit may be increased. Because the energy required to deliver cooling fluid at a higher temperature is lower than the energy required to deliver cooling fluid at a lower temperature, the CRAC unit may be operated at reduced energy levels. In addition, if the RHI level is below the RHI setpoint, the flow rate of cooling fluid supplied by the CRAC unit may be increased or decreased to bring the RHI level above the RHI setpoint.

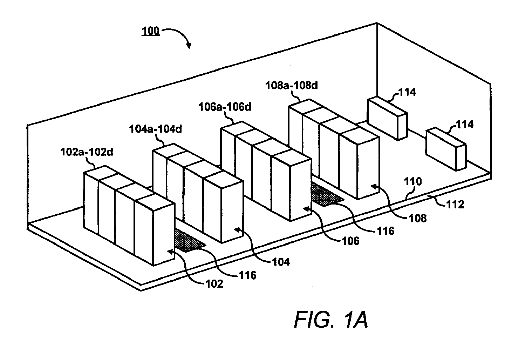

With reference first to FIG. 1A, there is shown a simplified perspective view of a data center 100 which may employ various examples of the invention. The terms "data center" are generally meant to denote a room or other space where one or more components capable of generating heat may be situated. In this respect, the terms "data center" are not meant to limit the invention to any specific type of room where data is communicated or processed, nor should it be construed that use of the terms "data center" limits the invention in any respect other than its definition hereinabove.

It should be readily apparent to those of ordinary skill in the art that the data center 100 depicted in FIG. 1A represents a generalized illustration and that other components may be added or existing components may be removed or modified without departing from the scope of the invention. For example, the data center 100 may include any number of racks and various other components. In addition, it should be understood that heat generating/dissipating components may be located in the data center 100 without being housed in racks.

The data center 100 is depicted as having a plurality of racks 102-108, for instance, electronics cabinets, aligned in parallel rows. Each of the rows of racks 102-108 is shown as containing four racks (a-d) positioned on a raised floor 110. A plurality of wires and communication lines (not shown) may be located in a space 112 beneath the raised floor 110. The space 112 may also function as a plenum for delivery of cooling fluid from one or more computer room air conditioning (CRAC) units 114 to the racks 102-108. The cooling fluid may be delivered from the space 112 to the racks 102-108 through vent tiles 116 located between some or all of the racks 102-108. The vent tiles 116 are shown as being located between racks 102 and 104 and 106 and 108.

As previously described, the CRAC units 114 generally operate to supply cooled cooling fluid into the space 112. The cooling fluid contained in the space 112 may include cooling fluid supplied by one or more CRAC units 114. Thus, characteristics of the cooling fluid, such as, temperature, pressure, flow rate, etc., may substantially be affected by one or more of the CRAC units 114. By way of example, the cooling fluid supplied by one CRAC unit 114 may mix with cooling fluid supplied by another CRAC unit 114. In this regard, characteristics of the cooling fluid at various areas in the space 112 and the cooling fluid supplied to the racks 102-108 may vary, for instance, if the temperatures or the volume flow rates of the cooling fluid supplied by these CRAC units 114 differ due to mixing of the cooling fluid. In certain instances, the level of influence may be higher at locations closer to the CRAC units 114 and lower at locations that are relatively farther away from the CRAC units 114. Therefore, the CRAC units 114 may be operated in manners to enable the temperatures and the volume flow rates of cooling fluid supplied into the racks 102-108 to be controlled with regard to the influences of the various CRAC units 114.

The racks 102-108 are generally configured to house a plurality of components capable of generating/dissipating heat(notshown), for instance, processors, micro-controllers, high-speed video cards, memories, semi-conductor devices, and the like. The components may be elements of a plurality of subsystems (not shown), for instance, computers, servers, etc. The subsystems and the components may be implemented to perform various electronic, for instance, computing, switching, routing, displaying, and the like, functions. In the performance of these electronic functions, the components, and therefore the subsystems, may generally dissipate relatively large amounts of heat. Because the racks 102-108 have generally been known to include upwards of forty (40) or more subsystems, they may transfer substantially large amounts of heat to the cooling fluid to maintain the subsystems and the components generally within predetermined operating temperature ranges.

Although the data center 100 is illustrated as containing four rows of racks 102-108 and two CRAC units 114, it should be understood that the data center 100 may include any number of racks, for instance, 100 or more racks, and CRAC units, for instance, four or more units. The depiction of four rows of racks 102-108 and two CRAC units 114 is thus for illustrative and simplicity of description purposes only and is not intended to limit the invention in any respect. In addition, the CRAC units 114 may also be positioned substantially perpendicularly to racks 102-108.

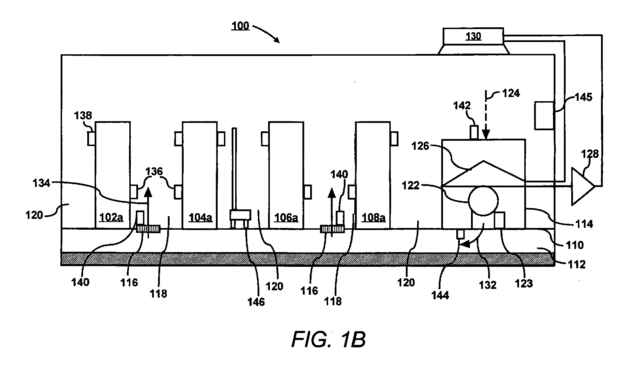

With reference now to FIG. 1B, there is shown a simplified illustration of a side elevational view of the data center 100 shown in FIG. 1A. In FIG. 1B, racks 102a, 104a, 106a, and 108a are visible. A more detailed description of the embodiments illustrated with respect to FIG. 1B may be found in commonly assigned U.S. Patent No. 6,574,104, filed on October 5, 2001, which is hereby incorporated by reference in its entirety.

As shown in FIG. 1 B, the areas between the racks 102 and 104 and between the racks 106 and 108 may comprise cool aisles 118. These aisles are considered "cool aisles" because they are configured to receive cooling fluid from the vent tiles 116. In addition, the racks 102-108 generally receive cooling fluid from the cool aisles 118. The aisles between the racks 104 and 106, and on the rear sides of racks 102 and 108, are considered hot aisles 120. These aisles are considered "hot aisles" because they are positioned to receive cooling fluid heated by the components in the racks 102-108. By substantially separating the cool aisles 118 and the hot aisles 120, for instance, with the racks 102-108, the cooling fluid may substantially be prevented from re-circulating with the heated cooling fluid prior to delivery into the racks 102-108. In addition, the heated cooling fluid may also substantially be prevented from re-circulating with the cooling fluid prior to returning to the CRAC units 114. However, there may be areas in the data center 100 where re-circulation of the cooling fluid and the heated cooling fluid occurs. By way of example, cooled cooling fluid may mix with heated cooling fluid around the sides or over the tops of one or more of the racks 102-108.

The sides of the racks 102-108 that face the cool aisles 118 may be considered as the fronts of the racks and the sides of the racks 102-108 that face away from the cool aisles 118 may be considered as the rears of the racks 102-108. For purposes of simplicity and not of limitation, this nomenclature will be relied upon throughout the present disclosure to describe the various sides of the racks 102-108.

According to another embodiment of the invention, the racks 102-108 may be positioned with their rear sides adjacent to one another (not shown). In this embodiment, the vent tiles 116 may be provided in each aisle 118 and 120. In addition, the racks 102-108 may comprise outlets on top panels thereof to enable heated cooling fluid to flow out of the racks 102-108.

As described hereinabove, the CRAC units 114 generally operate to cool received heated cooling fluid. In addition, the CRAC units 114 supply the racks 102-108 with cooling fluid that has been cooled, through, for example, a process as described below. The CRAC units 114 generally include respective fans 122 for supplying cooling fluid (for instance, air) into the space 112 (in one example, the space 112 generally functions as a plenum). The fans 122 may also be operated to draw cooling fluid from the data center 100 (for instance, as indicated by the arrow 124). In operation, the heated cooling fluid enters into the CRAC units 114 as indicated by the arrow 124 and is cooled by operation of a cooling coil 126, a compressor 128, and a condenser 130, in a manner generally known to those of ordinary skill in the art. In terms of cooling system efficiency, it is generally desirable that the return heated cooling fluid is composed of the relatively warmest portion of the air in the data center 100. In addition, the fans 122 are employed to supply the cooled cooling fluid into the space 112. The speeds of the fans 122 may be varied to thereby vary the volume flow rate in which the cooled cooling fluid is supplied to the space 112 and/or to vary the volume flow rate of heated cooling fluid returned into the CRAC units 114.

In one regard, variable frequency drives (VFDs) 123 may be employed to control the speeds of the fans 122. The VFDs 123 may comprise any reasonably suitable VFDs that are commercially available from any number of manufacturers. The VFDs 123 generally operates to variably control the speed of an alternating current (AC) induction motor. More particularly, the VFDs 123 may operate to convert power from fixed voltages/fixed frequencies to variable voltages/ variable frequencies. By controlling the voltage/frequency levels of the fans 122, the volume flow rates of the cooling fluid supplied by the CRAC units 114 may also be varied.

Although the VFD 123 is illustrated as being positioned adjacent to the fan 122, the VFD 123 may be positioned at any reasonably suitable location with respect to the fan 122 without departing from a scope of the invention. The VFD 123 may be positioned, for instance, outside of either of the CRAC units 114 or various other locations with respect to the CRAC units 114.

Although reference is made throughout the present disclosure of the use of fans 122 to draw heated cooling fluid from the data center 100, it should be understood that any other reasonably suitable manner of air removal may be implemented without departing from the scope of the invention. By way of example, a fan or blower (not shown) separate from the fan 122 may be utilized to draw heated cooling fluid from the data center 100.

In addition, based upon the cooling fluid needed to cool the heat loads in the racks 102-108, the CRAC units 114 may be operated at various levels. For example, the respective capacities (the amount of work exerted on the refrigerant) of the compressors 128 and/or the speeds of the fans 122 may be modified to thereby control the temperature and the amount of cooling fluid flow delivered to the racks 102-108. In this respect, the compressor 128 may comprise a variable capacity compressor and the fan 122 may comprise a variable speed fan. The compressor 128 may thus be controlled to either increase or decrease the mass flow rate of a refrigerant therethrough.

Because the specific type of compressor 128 and fan 122 to be employed with embodiments of the invention may vary according to individual needs, the invention is not limited to any specific type of compressor or fan. Instead, any reasonably suitable type of compressor 128 and fan 122 that are capable of accomplishing certain aspects of the invention may be employed. The choice of compressor 128 and fan 122 may depend upon a plurality of factors, for instance, cooling requirements, costs, operating expenses, etc.

It should be understood by one of ordinary skill in the art that embodiments of the invention may be operated with constant speed compressors and/or constant speed fans. In one respect, control of cooling fluid delivery to the racks 102-108 may be effectuated based upon the pressure of the cooling fluid in the space 112. According to this embodiment, the pressure within the space 112 may be controlled through operation of, for example, a plurality of vent tiles 116 positioned at various locations in the data center 100. That is, the pressure within the space 112 may be kept essentially constant throughout the space 112 by selectively controlling the output of cooling fluid through the vent tiles 116. By way of example, if the pressure of the cooling fluid in one location of the space 112 exceeds a predetermined level, a vent located substantially near that location may be caused to enable greater cooling fluid flow therethrough to thereby decrease the pressure in that location. A more detailed description of this embodiment may be found in U.S. Application Ser. No. 10/303,761, filed on November 26, 2002 and U.S. Application Ser. No. 10/351,427, filed on January 27, 2003, which are assigned to the assignee of the present invention and are hereby incorporated by reference in their entireties.

In addition, or as an alternative to the compressor 128, a heat exchanger (not shown) may be implemented in the CRAC unit 114 to cool the fluid supply. The heat exchanger may comprise a chilled water heat exchanger, a centrifugal chiller (for instance, a chiller manufactured by YORK), and the like, that generally operates to cool cooling fluid as it passes over the heat exchanger. The heat exchanger may comprise a plurality of air conditioners. The air conditioners may be supplied with water driven by a pump and cooled by a condenser or a cooling tower. The heat exchanger capacity may be varied based upon heat dissipation demands. Thus, the heat exchanger capacity may be decreased where, for example, it is unnecessary to maintain the cooling fluid at a relatively low temperature.

In operation, cooling fluid generally flows from the respective fans 122 and into the space 112 as indicated by the arrow 132. The cooling fluid flows out of the raised floor 110 and into various areas of the racks 102-108 through the plurality of vent tiles 116 as indicated by the arrows 134. The vent tiles 116 may comprise the dynamically controllable vent tiles disclosed and described in the 6,574,104 patent. As described in that patent, the vent tiles 116 are termed "dynamically controllable" because they generally operate to control at least one of velocity, volume flow rate and direction of the cooling fluid therethrough. In addition, specific examples of dynamically controllable vent tiles 116 may be found in co-pending U.S. Application Ser. No. 10/351,427, filed on January 27, 2003, which is assigned to the assignee of the present invention and is incorporated by reference herein in its entirety.

As the cooling fluid flows out of the vent tiles 116, the cooling fluid may flow into the racks 102-108. The racks 102-108 generally include inlets (not shown) on their front sides to receive the cooling fluid from the vent tiles 116. The inlets generally comprise one or more openings to enable the cooling fluid to enter the racks 102-108. In addition, or alternatively, the front sides of some or all ofthe racks 102-108 may comprise devices for substantially controlling the flow of cooling fluid into the racks 102-108. Examples of suitable devices are described in co-pending and commonly assigned U.S. Patent Application Serial Nos. 10/425,621 and 10/425,624, both of which were filed on April 30, 2003, the disclosures of which are hereby incorporated by reference in their entireties.

The cooling fluid may become heated by absorbing heat dissipated from components located in the racks 102-108 as it flows through the racks 102-108. The heated cooling fluid may exit the racks 102-108 through one or more outlets located on the rear sides of the racks 102-108. In addition, or alternatively, the rear sides of some or all of the racks 102-108 may comprise devices for substantially controlling the flow of cooling fluid into the racks 102-108 and/or controlling the flow of heated cooling fluid out of the racks 102-108. Again, examples of suitable devices are described in co-pending and commonly assigned U.S. Patent Application Serial Nos. 10/425,621 and 10/425,624.

The flow ofcooling fluid through the racks 102-108 may substantially be balanced with the flow of cooling fluid through the vent tiles 116 through operation of the above-described devices in manners consistent with those manners set forth in the above-identified co-pending applications. In addition, a proportional relationship may be effectuated between the airflow through the racks 102-108 and the vent tiles 116. In one respect, by virtue of controlling the airflow in the manners described in those co-pending applications, the level of re-circulation between the heated cooling fluid and the cooling fluid may substantially be reduced or eliminated in comparison with known cooling systems.

The CRAC units 114 may vary the amount of cooling fluid supplied to the racks 102-108 as the cooling requirements vary according to the heat loads in the racks 102-108, along with the subsequent variations in the volume flow rate of the cooling fluid. As an example, if the heat loads in the racks 102-108 generally increases, the one or more CRAC units 114 may operate to decrease the temperature of the cooling fluid and/or increase the supply of the cooling fluid. Alternatively, if the heat loads in the racks 102-108 generally decreases, the one or more CRAC units 114 may operate to increase the temperature of the cooling fluid and/or decrease the supply of the cooling fluid. In this regard, the amount of energy utilized by the one or more CRAC units 114 to generally maintain the components in the data center 100 within predetermined operating temperature ranges may substantially be optimized.

As an alternative, there may arise situations where the additional cooling fluid flow to the racks 102-108 causes the temperatures of the components to rise. This may occur, for example, when a relatively large amount of heated cooling fluid is re-circulated into the cooling fluid delivered into the racks 102-108. In this situation, and as will be described in greater detail hereinbelow, cooling fluid delivery may be reduced in response to increased component temperatures. In addition, cooling fluid delivery may be increased in response to decreased component temperatures. It should therefore be understood that the present invention is not limited to one operational manner as temperatures in the data center 100 vary.

Through operation of the vent tiles 116, the above-described devices, and the CRAC units 114, global and zonal control of the cooling fluid flow and temperature may be achieved. For instance, the vent tiles 116 and the above-described devices generally provide localized or zonal control of the cooling fluid flow to the racks 102-108. In addition, the CRAC units 114 generally provide global control of the cooling fluid flow and temperature throughout various portions of the data center 100. By virtue ofthe zonal and global control of the cooling fluid, the amount of energy consumed by the CRAC units 114 in maintaining the components of the racks 102-108 within predetermined operating temperature ranges may substantially be reduced in comparison with conventional data center cooling systems.

A plurality of temperature sensors 136-144, for instance, thermistors, thermocouples, etc., may be positioned at various locations throughout the data center 100. By way of example, temperature sensors (inlet temperature sensors) 136 may be provided at the inlets of the racks 102-108 to detect the temperature of the cooling fluid delivered into the racks 102-108. Temperature sensors (outlet temperature sensors) 138 may also be provided at the outlets of the racks 102-108 to detect the temperature of the heated cooling fluid exhausted from the racks 102-108. Temperature sensors (vent tile temperature sensors) 140 may further be located at the vent tiles 116 to detect the temperature of the cooling fluid supplied from the space 112. In addition, temperature sensors (return temperature sensors, supply temperature sensors) 142, 144 may respectively be positioned near the inlet and outlet of the CRAC units 114 to respectively detect the temperatures of the heated cooling fluid entering the CRAC units 114 and the cooling fluid delivered to the space 112.

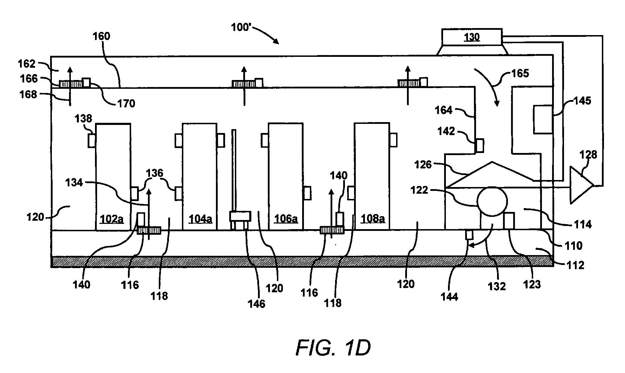

The temperature sensors 136-144 may communicate with one another and/or a computing device 145 configured to control operations of the data center cooling system. The computing device 145 may comprise a separate computing system which may include a processor, inputting means, etc. Alternatively, the computing device 145 may comprise part of one or more of the CRAC units 114, a component, for instance, a server, housed in a rack, etc. In any regard, the data center cooling system generally includes, the CRAC units 114, vent tiles 116, return tiles (FIG. 1D), etc. Communications between various sensors 136-144 and the computing device 145 may be effectuated via a wired protocol, such as IEEE 802.3, etc., wireless protocols, such as IEEE 801.11b, 801.11g, wireless serial connection, Bluetooth, etc., or combinations thereof. In addition, or alternatively, one or more ofthe temperature sensors 136-144 may comprise location aware devices as described in co-pending and commonly assigned U.S. Patent Application Serial No. 10/620,272, filed on July 9, 2003, entitled "LOCATION AWARE DEVICES", the disclosure of which is hereby incorporated by reference in its entirety. As described in that application, these devices are termed "location aware" because they are operable to determine their general locations with respect to other sensors and/or devices and to communicate with one another through wireless communications.

According to another embodiment, a mobile device 146 may be provided to gather or measure at least one environmental condition (for instance, temperature, pressure, air flow, humidity, location, etc.) in the data center 100. More particularly, the mobile device 146 may be configured to travel around the racks 102-108 to determine the one or more environmental conditions at various locations throughout the data center 100. In this regard, the mobile device 146 may enable temperatures in the data center 100 to be detected at various locations thereof while requiring substantially fewer temperature sensors. A more detailed description of the mobile device 146 and its operability may be found in co-pending and commonly assigned U.S. Application Serial No. 10/157,892, filed on May 31, 2002, the disclosure of which is hereby incorporated by reference in its entirety.

As described in the 10/157,892 application, the mobile device 146 may be a self-propelled mechanism configured for motivation around the racks 102-108 of the data center 100. In addition, the mobile device 146 generally includes a plurality of sensors configured to detect one or more environmental conditions at various heights. The mobile device 146 may transmit the environmental condition information to, for instance, the computing device 145, which may utilize the information in determining delivery of cooling fluid to the racks 102-108 in the data center 100. In addition, the mobile device 146 may transmit the environmental condition information to vent controllers (not shown) configured to operate the vent tiles 116.

According to another embodiment, the mobile device 146 may receive environmental information from temperature sensors comprising configurations similar to the location aware device described hereinabove. For example, the sensors may transmit a temperature measurement to the mobile device 146 indicating a hot spot, for instance, a location where the temperature is substantially above normal. The mobile device 146 may alter its course to travel to the detected hot spot to verify the temperature measurement by the sensors.

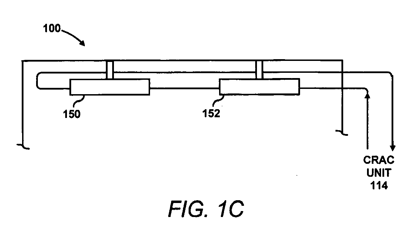

FIG. 1C is a cross-sectional side view of an upper portion of a data center 100 according to an embodiment ofthe invention. As illustrated in FIG. 1C, heat exchanger units (HEU's) 150 and 152 may be provided in the data center 100. The HEU's 150 and 152 are disclosed and described in co-pending U.S. Application Ser. No. 10/210,040, filed on August 2, 2002, which is assigned to the assignee of the present invention and is hereby incorporated by reference in its entirety. As described in the 10/210,040 application, the HEU's 150 and 152 generally operate to receive heated cooling fluid from the racks 102-108, cool the received cooling fluid, and deliver the cooled cooling fluid back to the racks 102a-108a in a substantially controlled manner. The HEU's 150 and 152 are configured to have refrigerant flow therethrough from the one or more of the CRAC units 114 to cool the heated cooling fluid they receive. The HEU's 150 and 152 generally include an opening to receive the heated cooling fluid and one or more fans to return the cooled air back to the racks 102-108. In addition, the HEU's 150 and 152 may also include temperature sensors (not shown) or temperature sensors may be located in the vicinities of the HEU's 150 and 152.

FIG. 1D shows a simplified schematic illustration of a data center 100 having a lowered ceiling 160. The data center 100 depicted in FIG. 1D contains all ofthe elements described with respect to FIG. 1B. Therefore, a detailed description of the common elements will not be described herein. Instead, the description provided hereinabove with respect to FIG. 1B is relied upon to provide an adequate description of these elements. In addition, only those elements that differ from the elements described in FIG. 1B will be described hereinbelow. A more detailed description of the elements contained in FIG. 1D may be found in co-pending and commonly assigned U.S. Patent Application Serial No. 10/262,879, entitled "Cooling of Data Centers", filed on October 2, 2002, the disclosure of which is incorporated by reference herein in its entirety.

As shown in FIG. 1D, the data center 100 includes a system for substantially greater focalized return of heated cooling fluid to the CRAC units 114 as compared to the data center 100 depicted in FIG. 1B. The system includes a lowered ceiling 160 that creates a return plenum 162 configured to direct and convey the heated cooling fluid to one or more of the CRAC units 114. In addition, a duct 164 is provided to direct the heated cooling fluid flow, as indicated by the arrow 165, from the return plenum 162 to a CRAC unit 114. A plurality of return vent tiles 166 are positioned along openings in the lowered ceiling 160 to effectuate receipt of the heated cooling fluid as generally indicated by the arrows 168. The return vent tiles 166 generally operate to control removal of heated cooling fluid from various locations in the data center 100 . In one instance, the return vent tiles 166 are positioned substantially over the hot aisles 120 to enable removal of cooling fluid heated in the racks 102-108. By substantially controlling the locations in the data center 100 where the heated cooling fluid is removed, and by substantially separating the removed the heated cooling fluid from the cooling fluid contained in the data center 100, the level of re-circulation between the cooling fluid and the removed heated cooling fluid may substantially be reduced. In one regard, therefore, the temperature of the heated cooling fluid returned to the CRAC units 114 may substantially be maintained at relatively higher temperatures.

As described hereinabove, CRAC units 114 generally operate at greater efficiencies at higher return temperatures. The temperature of the heated cooling fluid supplied to the one or more CRAC units 114 may, moreover, be maintained at the highest level by controllably removing heating cooling fluid from the data center 100 . In one instance, the return vent tiles 166 may be configured as dynamically controllable vent tiles capable of controlling at least one of the volume flow rate and direction of heated cooling fluid removal from the data center 100 . The return vent tiles 166 may, for instance, comprise the dynamically controllable vent tiles disclosed and described in the 6,574,104 patent. In this example, by controlling the direction and/or volume flow rate of the heated cooling fluid removal, the return vent tiles 166 may be operated in manners to generally ensure that the heated cooling fluid contained in the return plenum 162 is substantially at is highest possible temperature. As another example, the return vent tiles 166 may also include fans (not shown) configured to vary the velocities at which the heated cooling fluid is removed from the data center 100.

The manners in which the return vent tiles 166 may be operated to vary the removal of heated cooling fluid removal may be based, for instance, upon the temperatures of the heated cooling fluid detected in the vicinities of the respective return vent tiles 166. The temperatures may be detected by temperatures sensors 170 (return vent tile temperature sensors). Thus, for instance, if the temperature of the heated cooling fluid in the vicinity of a particular return vent tile 166 is below a predetermined temperature level, that return vent tile 166 may operate to decrease or cease removal of heated cooling fluid from that area.

According to an example, the temperatures detected by one or more of the sensors 136-144, the mobile device 146, and/or the temperature sensors located near the HEU's 150 and 152, may be implemented to determine metrics of re-circulation in the data center 100. The metrics may be defined as a supply heat index (SHI) and a return heat index (RHI). The SHI may be defined as a measure of the infiltration of heated cooling fluid into the cooling fluid and may be determined according to the following equation:

$$\text{equation (1): } SHI = \frac{\delta Q}{Q + \delta Q}$$

Where $Q$ represents the total heat dissipation from all the components in the racks 102-108 of the data center 100 and $\delta Q$ represents the rise in enthalpy of the cooling fluid before entering the racks 102-108.

The total heat dissipation may be determined by averaging the values obtained from subtracting the temperatures at the outlets of the racks 102-108 as detected by the outlet temperature sensors 138 from the temperatures at the inlets of the racks 102-108 as detected by inlet temperature sensors 140. The total heat dissipation $Q$ and the rise in enthalpy $\delta Q$ of the cooling fluid may be determined by the following equations:

$$\text{equation (2): } Q = \sum_{j}\sum_{i} m^{r}_{i,j} C_{p} \left( (T^{r}_{out})_{i,j} - (T^{r}_{in})_{i,j} \right)$$

$$\text{equation (3): } \delta Q = \sum_{j}\sum_{i} m^{r}_{i,j} C_{p} \left( (T^{r}_{in})_{i,j} - T_{ref} \right)$$

Where $m^{r}_{ij}$ is the mass flow rate through the $ith$ rack in the $jth$ row of racks, Cp is the specific heat of air, and $(T^{r}_{in})i,j$ and $(T^{r}_{out})i,j$ are average inlet and outlet temperatures from the $ith$ rack in the $jth$ row of racks. In addition, $T_{ref}$ denotes the vent tile 116 cooling fluid temperature, which is assumed to be identical for all the cool aisles 118.

The numerator in equation I denotes the sensible heat gained by the cooling fluid in the cool aisles before entering the racks 102-108, while the denominator represents the total sensible heat gained by the cooling fluid leaving the rack exhausts. Because the sum of the mass flow rates is equal for equations 2 and 3, SHI may be written as a function of rack inlet, rack outlet and CRAC unit 114 outlet temperatures. Thus, SHI may be represented as follows:

$$\text{equation (4): } SHI = \left[ \frac{\sum_{j}\sum_{i} \left( (T^{r}_{in})_{i,j} - T_{ref} \right)}{\sum_{j}\sum_{i} \left( (T^{r}_{out})_{i,j} - T_{ref} \right)} \right]$$

SHI may also be calculated for a cluster of racks in an aisle to evaluate the infiltration of heat into specific cool aisles. Moreover, SHI may be calculated for individual racks to isolate areas susceptible to hot spots. Equations 1 and 3 indicate that higher $\delta Q$ leads to higher $(T^r_{in})_{i,j}$ and hence, a higher SHI. When the inlet temperature $T^r_{in}$ to the rack rises relative to $T_{ref}$, systems become more vulnerable to failure and reliability problems. Increased $T^r_{in}$ also signifies increased entropy generation due to mixing and reduced energy efficiency for the data center 100. Therefore SHI can be an indicator of thermal management and energy efficiency in a rack, a cluster of racks, or the data center.

An SHI of zero indicates a prefect system with no re-circulation of heated cooling fluid into the cooled cooling fluid. Therefore, as described hereinbelow, one goal in operating the components of a data center cooling system is to minimize SHI.

The heated cooling fluid from the rack 102-108 exhausts is drawn up into the ceiling space of the data center 100. Alternatively, the heated cooling fluid may be drawn up into the return plenum 162 as shown in FIG. 1D. The heated cooling fluid then flows into the inlet of one or more CRAC units 114. During some or all of this flow, the heated cooling fluid may mix with the cooling fluid from the cool aisles 118 and may thus lose some of its heat. The quantity of heat loss in this process is equal to the secondary heat acquired by the cooling fluid in the cool aisles 118. From overall heat balance in the data center 100, the total heat dissipation (Q) from all the racks 102-108 should be equal to the total cooling load of the one or more CRAC units 114. Therefore, the heat balance in the data center 100 between the rack exhausts and the returns of the CRAC units 114 may be written as follows:

$$\text{equation (5):}\ \delta Q = \sum_j \sum_i m^r_{i,j}\, C_p \left( (T^r_{out})_{i,j} - T_{ref} \right) - \sum_k M_k\, C_p \left( (T^c_{in})_k - T_{ref} \right)$$

Where $M_k$ is the mass flow rate of cooling fluid through a CRAC unit, for instance, CRAC unit 114, and $T^c_{in}$ is the individual CRAC unit inlet temperature.

In equation 5, the first term in the right hand side denotes the total enthalpy $(Q + \delta Q)$ of the heated cooling fluid exhausted from the racks 102-108. The second term denotes the decrease in enthalpy due to mixing of heated cooling fluid and cooling fluid streams. Normalizing equation 5 with respect to the total exhaust cooling fluid enthalpy and rearranging yields:

$$\text{equation (6):}\ SHI + RHI = 1$$

Where RHI is the return heat index and is defined by the following equation:

$$\text{equation (7):}\ RHI = \left[ \frac{Q}{Q + \delta Q} \right] = \frac{\sum_k M_k C_p \left( (T^c_{in})_k - T_{ref} \right)}{\sum_j \sum_i m^r_{i,j} C_p \left( (T^r_{out})_{i,j} - T_{ref} \right)}.$$

In equation 7, the numerator denotes the total heat extraction by the CRAC unit(s) 114 and the denominator denotes the total enthalpy rise at the rack exhaust. Since the heat extracted by the CRAC unit(s) 114 is also equal to the heat dissipation from the racks, the numerator represents the effective heat dissipation in the data center 100.

An increase in $T^r_{in}$ generally results in a rise in $T^r_{out}$ on the return side ofthe racks 102-108, provided the heat load in the racks 102-108 is constant. For equation 7, it is apparent that this change in temperature would reduce RHI, indicating that the cooling fluid undergoes a higher degree of mixing before reaching the CRAC unit(s) 114. Heated cooling fluid from the rack exhausts may mix with cooling fluid inside the hot aisle, in the ceiling space, or in the space between the racks and the walls. To investigate local mixing in each row, RHI may be evaluated in an aisle-based control volume between the aisle exhaust and the rack exhaust or it can be inferred from calculation of SHI through known temperature data and equation 6. Higher values ofRHI generally indicate better aisle designs with low mixing levels.

According to an embodiment of the invention, data center cooling systems components, for instance, CRAC unit(s) 114, may be operated in manners to generally increase RHI values. Manners in which the CRAC unit(s) 114 may be operated to generally increase RHI values are described in greater detail hereinbelow.

A more detailed description of the equations above along with examples in which SHI and RHI may be used in the context of data centers may be found in a pair of articles published by the inventors of the present invention. The first article was published in the American Institute of Aeronautics and Astronautics on June 24, 2002, and is entitled "Dimensionless Parameters for Evaluation of Thermal Design and Performance of Large-Scale Data Centers." The second article was published in the April 2003 edition of the International Journal of Heat, Ventilating, Air-conditioning and Refrigeration Research, and is entitled "Efficient Thermal Management of Data Centers - Immediate and Long-Term Research Needs." The disclosures contained in these articles are hereby incorporated by reference in their entireties.

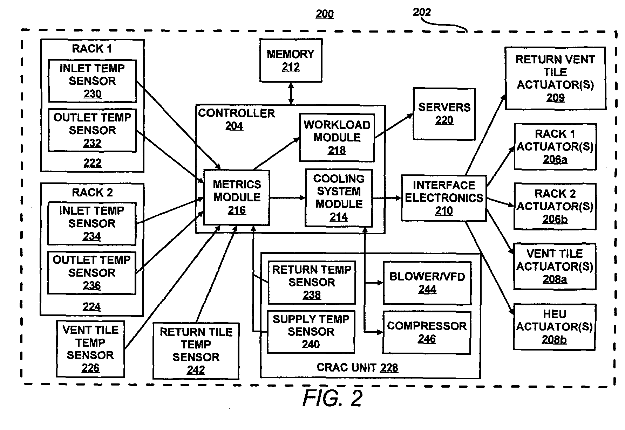

FIG. 2 is a block diagram 200 for a cooling system 202 according to an embodiment of the invention. It should be understood that the following description of the block diagram 200 is but one manner of a variety of different manners in which such a cooling system 202 may be operated. In addition, it should be understood that the cooling system 202 may include additional components and that some of the components described may be removed and/or modified without departing from a scope of the cooling system 202.

The cooling system 202 includes a controller 204 configured to control the operations of the cooling system 202. The controller 204 may, for instance, comprise the computing device 145 shown in FIGS. 1B and 1D. Alternatively, the controller 204 may comprise a computing device that is either part of one or more CRAC units 114, a component in the data center 100, 100 , etc.

By way of example, the controller 204 may control actuators 206a, 206b for a first rack 222 and a second rack 224, vent tile actuator(s) 208a, return vent tile actuator(s) 209, and/or HEU actuator(s) 208b to vary airflow characteristics in the data center 100, 100 . As another example, the controller 204 may control the workload placed on various servers 220 in the data center 100, 100. The controller 204 may comprise a microprocessor, a micro-controller, an application specific integrated circuit (ASIC), and the like.

The first rack actuator(s) 206a and the second rack actuator(s) 206b may be configured to manipulate an apparatus configured to vary the airflow through the racks, for instance, racks 102-108. Examples of suitable actuators 206a, 206b and apparatuses may be found in co-pending U.S. Patent Application Serial No. 10/425,621, entitled "Louvered Rack", and 10/425,624, entitled "Electronics Rack Having an Angled Panel", both of which were filed on April 30, 2003. The disclosures of these applications are incorporated by reference herein in their entireties. As described in those patent applications, a louver assembly or an angled panel may be provided on a rack and may be operated to vary the airflow through the racks.

The vent tile actuator(s) 208a may comprise an actuator configured to vary the airflow through the vent tile 116. Examples of suitable vent tile actuators 208a and vent tiles configured to vary the cooling fluid flow therethrough may be found in co-pending and commonly assigned U.S. Patent Application Serial No. 10/375,003, entitled "Cooling of Data Centers", filed on February 28, 2003, the disclosure of which is hereby incorporated by reference in its entirety. A discussion of various operational modes for these types of vents is disclosed in U.S. Patent No. 6,574,104.

The HEU actuator(s) 208b may comprise an actuator configured to vary the cooling fluid flow into and out of the HEU's 150 and 152. For instance, the HEU actuator(s) 208b may be configured to operate the one or more fans of the HEU's 150 and 152. Examples of suitable HEU actuators 208b may be found in the above-identified application serial number 10/210,040. In addition, the return vent tile actuator(s) 209 may comprise an actuator as described hereinabove with respect to FIG. 1D.

Interface electronics 210 may be provided to act as an interface between the controller 204 and the first rack actuator(s) 206a, second rack actuator(s) 206b, the vent tile actuator(s) 208a, the return vent tile actuator(s) 209, and the HEU actuator(s) 208b. The interface electronics 210 may instruct the first rack actuator(s) 206a, second rack actuator(s) 2066, the vent tile actuator(s) 208a, and/or the return vent tile actuator(s) 209 to vary its operation to thereby vary the airflow therethrough. By way of example, the interface electronics 210 may vary the voltage supplied to the vent tile actuator(s) 208a to vary the direction and/or magnitude of rotation of a drive shaft of the vent tile actuator(s) 208a in accordance with instructions from the controller 204.

The controller 204 may also be interfaced with a memory 212 configured to provide storage of a computer software that provides the functionality of the cooling system 202. The memory 212 may be implemented as a combination of volatile and non-volatile memory, such as DRAM, EEPROM, flash memory, and the like. The memory 212 may also be configured to provide a storage for containing data/information pertaining to the manner in which the rack actuators 206a and 206b, the vent tile actuator(s) 208a, the return vent tile actuator(s) 209 and the HEU actuator 208b may be manipulated in response to, for example, calculated SHI determinations.

The controller 204 may contain a cooling system module 214 configured to transmit control signals to the interface electronics 210. The cooling system module 214 may receive instructions from a metrics module 216 configured to calculate one or both of SHI and RHI. SHI and RHI may be calculated, for instance, in manners set forth hereinabove with respect to FIG. 1B. The cooling system module 214 may also be configured to control operations of one or more CRAC units 228 based upon calculated SHI or RHI levels as described in greater detail hereinbelow. The controller 204 may also comprise a workload module 218 configured to communicate with the metrics module 216. The workload module 218 may operate to distribute workload between a plurality of servers 220 in response to the calculated one or both ofSHI and RHI.

In one respect, the cooling system module 214 may transmit instructions for the rack actuators 206a and 206b, the vent tile actuator(s) 208a, the return vent tile actuator(s) 209 and/or the HEU actuator 208b to become manipulated in a manner to generally reduce SHI. In addition, these instructions may be directed to generally increasing RHI. In addition, or in the alternative, the workload module 218 may distribute the workload among various servers 220 to generally reduce SHI values and/or generally increase RHI values.

As described hereinabove, the SHI values and RHI values may be calculated based upon the temperatures of cooling fluid and heated cooling fluid at various locations of the data center 100, 100 . In one regard, the temperatures implemented in calculating SHI may be detected at one or more of the rack inlets and outlets, supply vent tiles, and the inlets and outlets of CRAC unit(s) 228.

FIG. 2 illustrates two racks 222 and 224, a vent tile temperature sensor 226, and CRAC unit 228 for purposes of simplicity of description and not of limitation. It should, however, be understood that the following description of the block diagram 200 may be implemented in data centers 100 having any number of racks, vent tiles and CRAC units without departing from the scope of the cooling system 202.

The first rack 222 is illustrated as having a first inlet temperature sensor 230 and a first outlet temperature sensor 232. The second rack 224 is illustrated as having a second inlet temperature sensor 234 and a second outlet temperature sensor 236. The temperature sensors 230-236 are illustrated as communicating with the controller 204, and more particularly, with the metrics module 216. The vent tile temperature sensor 226 and a return tile temperature sensor 242 are also illustrated as communicating with the metrics module 216. In addition, the CRAC unit 228 is depicted as comprising a return temperature sensor 238 and a supply temperature sensor 240, which are also in communication with the metrics module 216. The temperature sensors 226 and 230-242 may comprise one or more of the respective temperature sensors 136-144 and 170 described hereinabove with respect to, for instance, FIG. 1D.

The temperature sensors 226, 230-242 may comprise thermocouples, thermistors, or other devices configured to sense temperature and/or changes in temperature. The first and second inlet temperature sensors 230 and 234 are configured to detect temperatures of the cooling fluid entering through inlets of the first and second racks 222, 224, respectively. The first and second outlet temperature sensors 232, 236 are configured to detect temperatures of the heated cooling fluid exhausting through the outlet(s) at various locations of the first and second racks 222, 224, respectively. The vent tile temperature sensor 226 is configured to detect the temperature of the cooling fluid delivered through a vent tile, for instance, vent tile 116. The return vent tile temperature sensor 242 is configured to detect the temperature of the heated cooling fluid removed from the data center 100. The return temperature sensor 238 and the supply temperature sensor 240 are configured to detect the respective temperatures of heated cooling fluid flow into and cooled cooling fluid out of the CRAC unit 228.

The controller 204 may receive detected temperatures from the sensors 226 and 230-242 through wired connections or through wireless protocols, such as IEEE 801.11b, 801.11g, wireless serial connection, Bluetooth, etc., or combinations thereof. The metrics module 216 may calculate one or both of the SHI and RHI values based upon the received detected temperatures. In one regard, the metrics module 216 may determine the SHI values and/or the RHI values at various locations of the data center 100, 100 . For example, the metrics module 216 may determine the SHI values and/or the RHI values for one or more components, one rack, a cluster of racks, multiple clusters of racks, or the entire data center 100, 100 . The metrics module 216 may also provide the SHI values and/or RHI values to the cooling system module 214 and the workload module 218.

As described hereinabove with respect to co-pending U.S. Patent Application Serial No. 10/620,272, entitled "Location Aware Device", filed on July 9, 2003, the temperature sensors 226, 230-242 may comprise location aware devices. Through use of location aware devices as described in that application, the controller 204 may determine and store the locations of the various sensors. In addition, the controller 204 may wirelessly receive temperature information from the sensors and may be configured to substantially automatically determine the sensor locations in the event the data center is re-configured.

As stated hereinabove, the metrics module 216 may be configured to calculate one or both of the SHI and RHI values based upon the equations described hereinabove. The RHI values may be used to control operations of one or more CRAC units 228. More particularly, based upon the calculated RHI values, the cooling system module 214 may operate one or both of the blower/VFD 244 and the compressor 246 to vary a characteristic of the cooling fluid supplied by the one or more CRAC units 228. As will be described in greater detail hereinbelow, the blower/VFD 244 and the compressor 246 may be operated by the cooling system module 214 in various manners to enable the one or more CRAC units 228 to be operated in substantially optimized energy efficient manners, while maintaining desired thermal management goals.

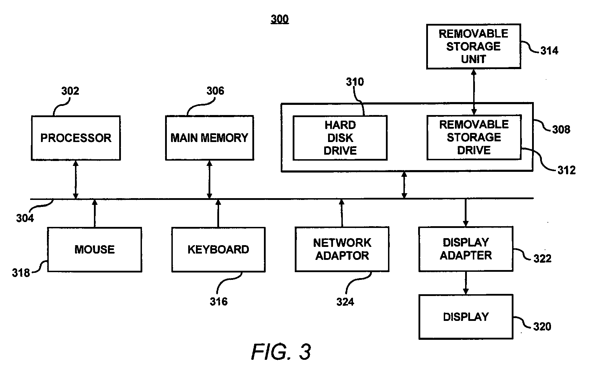

FIG. 3 illustrates a computer system 300, which may function as either or both of the computing device 145 and the controller 204. In this respect, the computer system 300 may be used as a platform for executing one or more of the modules contained in the controller 204.

The computer system 300 includes one or more controllers, such as a processor 302. The processor 302 may be used to execute programs or modules (for instance, modules 216-218 of the cooling system 202). Commands and data from the processor 302 are communicated over a communication bus 304. The computer system 300 also includes a main memory 306, for instance, the memory 212, such as a random access memory (RAM), where the program code for the cooling system 202 may be executed during runtime, and a secondary memory 308. The secondary memory 308 includes, for example, one or more hard disk drives 310 and/or a removable storage drive 312, representing a floppy diskette drive, a magnetic tape drive, a compact disk drive, etc., where a copy of the program code for the provisioning system may be stored.

The removable storage drive 310 reads from and/or writes to a removable storage unit 314 in a well-known manner. User input and output devices may include a keyboard 316, a mouse 318, and a display 320. A display adaptor 322 may interface with the communication bus 304 and the display 320 and may receive display data from the processor 302 and convert the display data into display commands for the display 320. In addition, the processor 302 may communicate over a network, for instance, the Internet, LAN, etc., through a network adaptor 324.

It will be apparent to one of ordinary skill in the art that other known electronic components may be added or substituted in the computer system 300. In addition, the computer system 300 may include a system board or blade used in a rack in a data center, a conventional "white box" server or computing device, etc. Also, one or more of the components in FIG. 3 may be optional (for instance, user input devices, secondary memory, etc.).

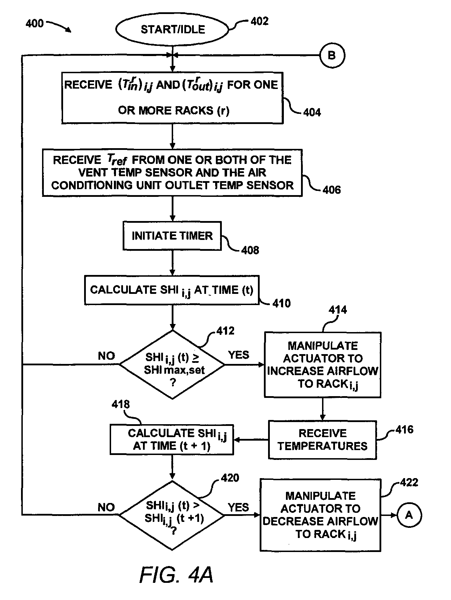

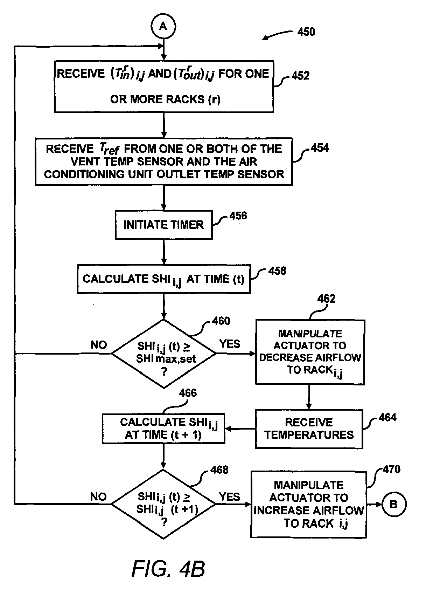

FIGS. 4A and 4B, collectively, illustrate flow diagrams of operational modes 400 and 450 of a cooling system, for instance, the cooling system 202. It is to be understood that the following description of the operational modes 400 and 450 are but two manners of a variety of different manners in which embodiments of the invention may be operated. It should also be apparent to those of ordinary skill in the art that the operational modes 400 and 450 represent generalized illustrations and that other steps may be added or existing steps may be removed or modified without departing from the scope of the invention. The description of the operational modes 400 and 450 are made with reference to the block diagram 200 illustrated in FIG. 2, and thus makes reference to the elements cited therein.

The controller 204 may implement the operational mode 400 to control airflow through the data center 100 based upon calculated SHI values. The operational mode 400 may be initiated in response to a variety of stimuli at step 402. For example, the operational mode 400 may be initiated in response to a predetermined lapse of time, in response to receipt of a transmitted signal, and/or in response to a detected change in an environmental condition (e.g., temperature, humidity, location, etc.).

At step 404, the controller 204 may receive rack inlet temperature measurements from the inlet temperature sensors 230 and 234. The controller 204 may also receive rack outlet temperature measurements from the outlet temperature sensors 232 and 236. It should be understood that the controller 204 may receive the inlet and outlet temperature measurements from any number of racks, for instance, racks 102-108, at step 404.

At step 406, the controller 204 may receive a reference temperature $T_{ref}$ from one or both of the vent temperature sensor 226 and the CRAC unit supply temperature sensor 240. Under ideal conditions, for instance, no heat transfers into the cooling fluid as it travels from the CRAC unit 228 outlet to the vent tile 116, the temperature of the cooling fluid at the CRAC unit 228 outlet and the vent tile 116 are identical. The reference temperature $T_{ref}$ may be considered as either the temperature of the cooling fluid at the outlet of the CRAC unit 228 or at the vent tile 116. It may thus be understood that either temperature may be used in determining the SHI values, in the event that no heat transfer occurs during flow of the cooled cooling fluid from the CRAC unit 228 to the vent tile 116.

In addition, when HEU's 150 and 152 are used in the data center 100 to supply the racks 102-108 with cooling fluid, the reference temperature $T_{ref}$ may be considered as a temperature of the cooling fluid at the outlet of the HEU's 150 and 152. It should therefore be understood that this temperature may be used in determining the SHI values.

The controller 204 may initiate a timer at step 408 to track when the SHI value is calculated, as indicated at step 410. The timer may also be initiated prior to receipt of the temperature measurements at steps 404 and 406 to track when those measurements are received. At step 410, the controller 204, and more particularly, the metrics module 216 may perform the calculations based upon the equations listed hereinabove to determine the SHI values for the ith rack in the jth row. As stated hereinabove, the SHI values may be calculated based upon the rack inlet temperatures, the rack outlet temperatures, and the reference temperatures. In addition, step 410 and the steps that follow may be performed for individual racks, clusters of racks (for instance, all the racks in a particular row), or all of the racks in the data center 100, 100.

At step 412, the metrics module 216 may determine whether the calculated SHI values exceed or equal a maximum set SHI value (SHImax,set). The maximum set SHI value may be stored in the memory 212 and may be defined as a threshold SHI value that the controller 204 may use in determining whether to manipulate actuators that affect airflow through the racks. The maximum set SHI value may be selected according to a plurality of factors. These factors may include, for example, acceptable re-circulation levels, functional limits of the data center configuration, etc. In addition, the maximum set SHI values may vary from one rack to another or from one cluster of racks to another.

In addition, the metrics module 216 may determine the level of rise in SHI values. This determination may be made based upon, for example, previous SHI value calculations for a given component, rack, and/or clusters of racks. If an above-normal rise in SHI value is determined, the controller 204 may operate to cause an alarm to be sounded or otherwise signal that such a rise in SHI value has occurred. The level at which a SHI value is determined to be above-normal may depend upon a plurality of factors and may vary from component to component, rack to rack, and/or clusters of racks to other clusters of racks. Some of these factors may include, the positioning of the components or racks, the airflow characteristics in the locations of the components for the racks, acceptable heat dissipation characteristics, etc.

Thus, some of the racks or areas of the data center may have SHI values that are below the maximum set SHI value whereas other racks or areas of the data center may have SHI values that exceed their respective maximum set SHI values. For those racks or rack clusters having SHI values that fall below the maximum set SHI value, steps 404-412 may be repeated. These steps may be repeated in a substantially continuous manner. Alternatively, the controller 204 may enter into an idle or sleep state as indicated at step 402 and may initiate the control scheme 400 in response to one or more of the conditions set forth above.

For those racks or rack clusters that have SHI values that equal or exceed the maximum set SHI value, the controller 204 may manipulate one or more actuators 206a, 2066, 208a, 208b to increase the airflow through one or more ofthose racks or rack clusters at step 414. As stated hereinabove, the actuators 206a and 206b may be configured to vary the flow of air through respective racks 222 and 224. In this regard, the actuators 206a and 206b may control operation of movable louvers as set forth in co-pending U.S. Patent Application Serial No. 10/425,621 and/or angled panels as set forth in co-pending U.S. Patent Application Serial No. 10/425,624. In addition the vent actuator 208a may control delivery of cooling fluid to the cool aisles 118 to be supplied to the racks 222 and 224 as set forth in co-pending U.S. Patent No. 6,574,104 and U.S. Patent Application Serial No. 10/375,003.

Also, at step 414, the controller 204, and more specifically, the metrics module 216, may determine the level to which one or more actuators 206a, 2066, 208a, 2086 is to be manipulated. This determination may be based upon past performance considerations. For example, the controller 204 may store in the memory 212, calculated SHI values for various actuator 206a, 206b, 208a, 208b manipulations for a given component, rack, and/or clusters of racks. The metrics module 216 may utilize this information in determining the level of actuator 206a, 206b, 208a, 208b manipulation.

At step 416, the controller 204 may receive temperature measurements again from the sensors 226, 230-236, 240 at a later time than at step 404, for instance, at time t +1. These temperature measurements are used to calculate the SHI values at time t+1, as indicated at step 418. The SHI values calculated at time t are compared with the SHI values calculated at time t+1 to determine whether the manipulation(s) performed at step 414 produced the intended effect of reducing SHI and therefore reducing re-circulation of heated cooling fluid into the cooled cooling fluid, at step 420.

If the SHI value has been reduced, that is, the SHI value at time t exceeds the SHI value at time t+1, the controller 204 may repeat steps 404-420. These steps may be repeated according to a pre-set time schedule, or they may be repeated for so long as the data center and therefore the cooling system, is operational. Alternatively, the controller 204 may enter into an idle or sleep state as indicated at step 402 and may initiate the operational mode 400 in response to one or more of the conditions set forth above.

If the SHI value has not been reduced, that is, the SHI value at time t is less than or equal to the SHI value at time t+1, it may be determined that the manipulation of the actuator(s) 206a, 206b, 208a, 208b actually caused a rise in the SHI value. Thus, at step 422, the controller 204 may manipulate one or more of the actuators 206a, 206b, 208a, 208b to decrease the airflow through the racks. In one respect, the rise in SHI values could be an indication that re-circulation of the heated cooling fluid with the cooled cooling fluid may have increased due to the increased airflow through the racks. In this case, a second scheme (operational mode 450) may be invoked as illustrated in FIG. 4B, which will be described in greater detail hereinbelow.

According to the operational mode 400 illustrated in FIG. 4A, which will be considered as the first scheme, when the SHI values exceed or equal the maximum set SHI value, cooling fluid delivery to the racks may be increased (steps 404-414).

FIG. 4B illustrates the second scheme, operational mode 450, in the situation where the first scheme does not produce the intended effect of reducing SHI values. The second scheme may be initiated after step 422 of the first control scheme. In general, according to the second scheme, the controller 204 operates in a substantially opposite manner to that of the first scheme. That is, for example, under the second scheme, the controller 204 may manipulate the actuator(s) 206a, 206b, 208a, 208b to decrease the cooling fluid flow to the racks in response to the SHI values at time t exceeding or equaling the maximum set SHI value.

As illustrated in FIG. 4B, at steps 452 and 454, the controller 204 may again receive temperature information from the sensors 226, 230-236, 240. In addition, the controller 204 may initiate a timer prior to calculating the SHI values for the ith rack in thejth row from the detected temperature information or the controller 204 may initiate the timer when it receives the temperature information at step 456. At step 456, the controller 204, and more particularly, the metrics module 216 may perform the calculations listed hereinabove to determine the SHI values. In addition, step 456 and the steps that follow may be performed for individual racks, clusters of racks (e.g., all the racks in a particular row), or all of the racks in a data center. At step 460, the controller 204 may compare the calculated SHI values with the maximum set SHI value to determine whether the SHI values are below a desired value.

For those racks or rack clusters having SHI values that fall below the maximum set SHI value, steps 452-460 may be repeated. These steps may be repeated in a substantially continuous manner. Alternatively, the controller 204 may enter into an idle or sleep state, for instance, step 402, and may initiate the operational mode 450 in response to one or more of the conditions set forth above with respect to step 402.

For those racks or rack clusters that have SHI values that equal or exceed the maximum set SHI value, the controller 204 may manipulate one or more actuators 206a, 206b, 208a, 208b to decrease the airflow through one or more of those racks or rack clusters at step 462. As stated hereinabove, the actuators 206a and 206b may be configured to vary the flow of cooling fluid through respective racks 222 and 224. In this regard, the actuators 206a and 206b may control operation of movable louvers as set forth in co-pending U.S. Patent Application Serial No. 10/425,621 and/or angled panels as set forth in co-pending U.S. Patent Application Serial No. 10/425,624. In addition the vent actuator 208a may control delivery of cooling fluid to the cool aisles 118 to be supplied to the racks 222 and 224 as set forth in co-pending U.S. Patent No. 6,574,104 and U.S. Patent Application Serial No. 10/375,003.

At step 464, the controller 204 may receive temperature measurements again from the sensors 226, 230-236, 240 at a later time than at step 452, for instance, at time t +1. These temperature measurements are used to calculate the SHI values at time t+1, as indicated at step 466. The SHI values calculated at time t are compared with the SHI values calculated at time t+1 to determine whether the manipulation(s) performed at step 462 produced the intended effect of reducing SHI and therefore re-circulation of heated cooling fluid into the cooled cooling fluid, at step 468.

If the SHI has been reduced, that is, the SHI value at time t exceeds the SHI value at time t+1, the controller 204 may repeat steps 452-468. These steps may be repeated according to a pre-set time schedule, or they may be repeated for so long as the data center and therefore the cooling system, is operational. Alternatively, the controller 204 may enter into an idle or sleep state, e.g., step 402, and may initiate the operational mode 450 in response to one or more ofthe conditions set forth above with respect to step 402.

If the SHI has not been reduced, that is, the SHI value at time t is less than or equal to the SHI value at time t+1, it may be determined that the manipulation of the actuator(s) 206a, 206b, 208a, 208b actually caused a rise in the SHI value. Thus, at step 470, the controller 204 may manipulate one or more of the actuators 206a, 206b, 208a, 208b to increase the airflow through the racks. In one respect, the rise in SHI values could be an indication that re-circulation of the heated cooling fluid with the cooled cooling fluid may have been increased due to the decreased airflow through the racks. In this case, the first scheme (operational mode 400) may be invoked as illustrated in FIG. 4A.

Through implementation of the operational mode 450 in response to the first scheme producing an undesirable result and implementation of the operational mode 450 in response to the second scheme producing an undesirable result, the controller 204 may substantially learn an optimized manner of operating the actuators 206a, 206b, 208a, and 208b in response to various SHI value calculations. In this regard, the controller 204 may substantially adapt to changing conditions in the data center that may cause changing SHI values.

The first and second schemes may be repeated any number times, for instance, as long as the data center is operational, at predetermined time intervals, etc. Thus, the controller 204 may vary the cooling fluid delivery into the racks as SHI values change for various sections of the data center. In addition, the controller 204 may vary the airflow through the racks according to an iterative process. That is, the controller 204 may alter the airflow by a predetermined amount each time a change is warranted and repeat this process until the SHI values are below the maximum set SHI value.

In one regard, by controlling the cooling fluid delivery to reduce the SHI values and therefore to reduce re-circulation of heated cooling fluid into the cooled cooling fluid, the amount of energy required to maintain the temperatures of the components in the racks within predetermined ranges may substantially be optimized.

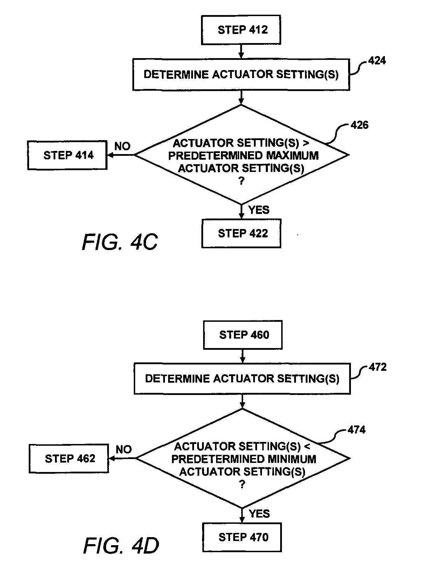

FIGS. 4C and 4D illustrate optional steps of the operational modes illustrated in FIGS. 4A and 4B, respectively, according to alternative embodiments of the invention. With reference first to FIG. 4C, there are shown steps 424 and 426 that may be performed in place of steps 414-420. According to this embodiment, following step 412, the settings of the one or more actuators 206a, 206b, 208a, 208b may be determined at step 424. The actuator settings may be based upon, for example, the degree to which a supply vent is open, the angle of an angled panel, the angles of movable louvers, etc. Thus, for example, the airflow through one or more vent tiles 116 and one or more racks 102-108 may be determined according to the actuator settings.

At step 426, the determined actuator settings are compared to predetermined maximum actuator settings. The predetermined maximum actuator settings may be based upon a plurality of factors. For instance, the predetermined maximum actuator settings may correlate to the maximum open position of the above-described airflow devices. Alternatively, the predetermined maximum actuator settings may correlate to a desired level of airflow through the airflow devices. That is, for example, the predetermined maximum actuator settings may be set to substantially prevent potentially damaging levels of cooling fluid flow through the one or more racks 102-108, such as, a situation where there is little or no cooling fluid flow through the one or more racks 102-108.

If the determined actuator settings are greater than the predetermined maximum actuator settings, the controller 204 may manipulate the one or more actuators 206a, 2066, 208a, 208b to decrease the cooling fluid flow to the one or more racks 102-108 at step 422. Alternatively, if the determined actuator settings are below the predetermined maximum actuator settings, the controller 204 may manipulate the one or more actuators 206a, 206b, 208a, 208b to increase the cooling fluid flow to the one or more racks 102-108 at step 414.

With reference now to FIG. 4D, there are shown steps 472 and 474 that may be performed in place of steps 462-468. According to this embodiment, following step 460, the settings of the one or more actuators 206a, 206b, 208a, 208b may be determined at step 472. The actuator settings may be based upon, for example, the degree to which a vent tile 116 is open, the angle of an angled panel, the angles of movable louvers, etc. Thus, for example, the airflow through one or more of the vent tiles 116 and one or more racks 102-108 may be determined according to the actuator settings.

At step 474, the determined actuator settings are compared to predetermined minimum actuator settings. The predetermined minimum actuator settings may be based upon a plurality of factors. For instance, the predetermined minimum actuator settings may correlate to the minimum open position of the above-described airflow devices. Alternatively, the predetermined minimum actuator settings may correlate to a desired level of cooling fluid flow through the airflow devices. That is, for example, the predetermined minimum actuator settings may be set to substantially prevent potentially damaging levels of cooling fluid flow through the one or more racks 102-108, such as, a situation where there is little or no cooling fluid flow through the one or more racks. If the determined actuator settings are less than the predetermined minimum actuator settings, the controller 204 may manipulate the one or more actuators 206a, 206b, 208a, 208b to increase the cooling fluid flow to the one or more racks 102-108 at step 470. Alternatively, if the determined actuator settings are above the predetermined minimum actuator settings, the controller 204 may manipulate the one or more actuators 206a, 206b, 208a, 208b to decrease the cooling fluid flow to the one or more racks 102-108 at step 462.

After performing the steps indicated in the operational modes 400 and 450, the controller 204 may determine which of the operational modes 400 and 450 to perform when changes to SHI are detected. For example, the controller 204 may implement operational mode 400 when a prior performance of operational mode 400, for instance, steps 402-420, resulted in a reduction in SHI for a component, rack, or cluster of racks. Alternatively, the controller 204 may implement operational mode 450 when a prior performance of operational mode 450, for instance, steps 452-468, resulted in a reduction in SHI for a component, rack, or cluster of racks. In addition, the controller 204 may implement either operational mode 400 or 450 in response to SHI determinations for various components, racks, or clusters of racks. In one regard, the controller 204 essentially learns which operational mode 400 or 450 to perform, for instance, manipulating the one or more actuators to increase or decrease cooling fluid flow in response to calculated SHI's exceeding the predetermined maximum set SHI.

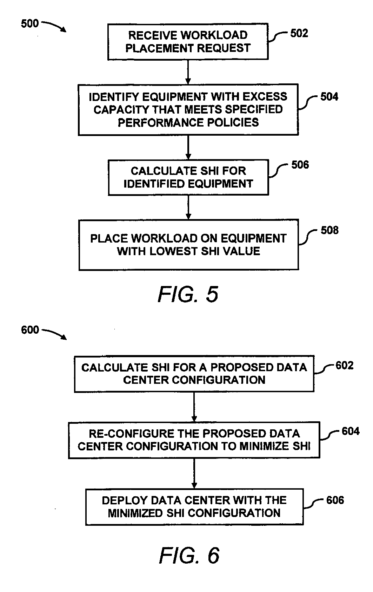

FIG. 5 illustrates a flow diagram of an operational mode 500 of a cooling system, for instance, cooling system 202, according to another implementation. It is to be understood that the following description of the operational mode 500 is but one manner of a variety of different manners in which an embodiment of the invention may be operated. It should also be apparent to those of ordinary skill in the art that the operational mode 500 represents a generalized illustration and that other steps may be added or existing steps may be removed or modified without departing from the scope of the invention. The description of the operational mode 500 is made with reference to the block diagram 200 illustrated in FIG. 2, and thus makes reference to the elements cited therein.

The controller 204 may implement the operational mode 500 to control workload through various servers 220 based upon calculated SHI values. The operational mode 500 may be initiated in response to receipt of a workload placement request at step 502. For example, the operational mode 500 may be initiated in response to a request for work to be performed by one or more servers 220.

At step 504, the controller 204, and more particularly the workload module 218 may identify equipment, for instance, one or more servers 220, that have excess capacity that meets specified performance policies. For example, the workload module 218 may determine which servers 220 are capable of performing the requested task.

At step 506, the workload module 218 may receive SHI values for the equipment identified in step 504. The workload module 218 may receive this information from the metrics module 218 which may calculate the SHI values in the manners described hereinabove. In addition, the workload module 218 may request that the workload module 218 perform the SHI calculations in response to receipt of the workload request.

The workload module 218 may place the workload on one or more equipment having the lowest SHI value at step 508. In this regard, the efficiency of the heat transfer from the equipment in the racks to the cooling fluid may substantially be optimized.

FIG. 6 illustrates a flow diagram of an operational mode 600 for designing and deploying a data center layout. It is to be understood that the following description of the operational mode 600 is but one manner of a variety of different manners in which an embodiment may be operated. It should also be apparent to those of ordinary skill in the art that the operational mode 600 represents a generalized illustration and that other steps may be added or existing steps may be removed or modified without departing from the scope of the invention.

Some of the steps outlined in the operational mode 600 may be performed by software stored, for example, in the memory 212, and executed by the controller 204. The software may comprise a computational fluid dynamics (CFD) tool designed to calculate airflow dynamics at various locations of a proposed data center based upon inputted temperatures. The CFD tool may be programmed to determine SHI values for various sections of the data center according to predicted temperatures at rack inlets and outlets, as well as predicted reference temperatures.

At step 602, based upon the proposed layout or configuration of the data center as well as the proposed heat generation in the racks, SHI values may be calculated. According to the calculated SHI values, the layout or configuration of the data center may be re-configured to minimize SHI values at step 604. Step 604 may comprise an iterative process in which various data center configurations are inputted into the tool to determine which layout results in the minimal SHI values. Once the layout is determined with the minimized SHI value configuration, the data center having this layout may be deployed at step 606.

As described in greater detail in the co-pending applications listed hereinabove, the CFD tool may be implemented to monitor the temperature of cooling fluid as well as the airflow in the data center 100. According to an embodiment of the present invention, the CFD tool may be implemented to calculate SHI values for various sections of the data center 100 to thus determine the level of heated cooling fluid re-circulation in the data center 100. For example, the temperatures of the cooling fluid delivered into the racks, the temperatures of the heated cooling fluid exhausted from the racks, and the reference temperature may be inputted into the CFD tool. The CFD tool may calculate the SHI values with the inputted temperature information in a manner similar to the equations set forth hereinabove. The CFD tool may further create a numerical model of the SHI values in the data center 400. The numerical model of the SHI values may be used in creating a map of the SHI values throughout various sections of the data center 100.

By comparing the numerical models of SHI values throughout the data center 100 at various times, the CFD tool may determine changes in SHI values in the data center 100. If the numerical models of the SHI values indicate that the cooling fluid is re-circulating with the heated cooling fluid, the controller 204 may manipulate one or more actuators 206a, 2066, 208a, 208b to reduce or eliminate the re-circulation in the manners described hereinabove with respect to FIGS. 4A and 4B.

As described in co-pending and commonly assigned Application Ser. No. 10/345,723, filed on January 22, 2003 and entitled "Agent Based Control Method and System for Energy Management" (Attorney DocketNo. 100200080), the disclosure of which is hereby incorporated by reference in its entirety, the actuator 206a, 206b, 208a, 208b movements may be considered as resources that may be traded or allocated among rack agents to distribute cooling fluid. These resources may be at the lowest tier of the resource pyramid and may be allocated first in response to a control signal. The multi-tiered and multi-agent control system may be driven by appropriate temperature conditions, deviations, and the rack operating parameters.

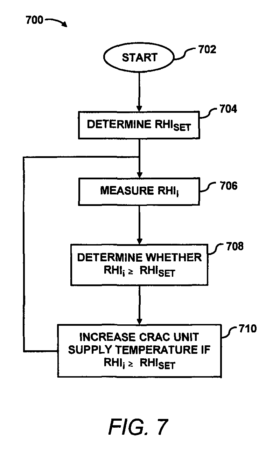

FIG. 7 illustrates a flow diagram of an operational mode 700 for a cooling system, for instance, the cooling system 202, based substantially upon RHI values. It is to be understood that the following description of the operational mode 700 is but one manner of a variety of different manners in which the cooling system may be operated. It should also be apparent to those of ordinary skill in the art that the operational mode 700 represents a generalized illustration and that other steps may be added or existing steps may be removed or modified without departing from the scope of the invention. The description of the operational mode 700 is made with reference to the block diagram 200 illustrated in FIG. 2, and thus makes reference to the elements cited therein.

In one regard, the controller 204 may implement the operational mode 700 to control one or more CRAC units 228 based upon calculated RHI values. More particularly, for instance, the operational mode 700 may be implemented to control one or more of the CRAC units 228 such that their energy consumption levels are substantially minimized. In addition, one or more of the CRAC units 228 may be operated in manners to generally maintain beneficial thermal management levels. Although particular reference is made to a single CRAC unit 228, it should be understood that the concepts outlined with respect to the operational mode 700 may be applied to control any reasonably suitable number of CRAC units 228. Accordingly, the description of a single CRAC unit 228 is for simplicity of description purposes and is not meant to limit the operational mode 700 to a single CRAC unit 228.

The operational mode 700 may be initiated in response to a variety of stimuli at step 702. For example, the operational mode 700 may be initiated in response to a predetermined lapse of time, in response to receipt of a transmitted signal, and/or in response to a detected change in an environmental condition (for instance, temperature, humidity, location, etc.). In addition, a user may manually initiate the operational mode 700.

At step 704, an RHI setpoint ($RHI_{SET}$) may be determined. The RHI setpoint may constitute, for instance, a minimum RHI level that yields acceptable results in the data center 100, 100 . The RHI setpoint may be determined based upon testing of the effects of various RHI levels in the data center 100, 100 to determine whether they are acceptable. In addition or alternatively, the RHI setpoint may be based upon manufacturer's specifications for the components contained in the data center 100, 100. For instance, the RHI setpoint may substantially be based upon acceptable temperature levels in the data center 100, 100. In addition, the RHI setpoint may differ for different CRAC units 228 as the areas they affect may differ.

In any regard, at step 706, the $RHI_i$ value for the CRAC unit 228 may be measured. The subscript "i" denotes the iteration index for the RHI iterations. Thus, for a first iteration, "i" would be equal to one (1), for a second iteration, "i" would be equal to two (2), and so forth. As described hereinabove, the RHI values are calculated based upon equation (7). Therefore, the temperatures of the cooling fluid at various locations of the data center 100, 100 may be used to determine the RHI values. More particularly, the RHI values are based upon the temperature of the heated cooling fluid returned $(T_{in}^{C})$ into the CRAC unit 228, the temperature of the heated cooling fluid exhausted from one or more racks

$(T''_{out})$, and the reference temperature of the cooled cooling fluid ($T_{ref}$). The reference temperature ($T_{ref}$) denotes the vent tile 116 cooling fluid temperature, which may also be considered as the supply temperature of the cooling fluid supplied by the CRAC unit 228. In addition, the one or more racks where the exhausted heated cooling fluid temperature ($T''_{out}$) is measured may be based upon the influence of the CRAC unit 228 over particular ones of the one or more racks.

At step 708, it may be determined whether the $RHI_i$ value determined at step 706 equals or exceeds the $RHI_{SET}$ value determined at step 704. At step 710, the temperature at which cooling fluid is supplied by the CRAC unit 228 is increased if the $RHI_i$ value is greater than or equal to the $RHI_{SET}$ value. The level of increase in the supply cooling fluid temperature of the CRAC unit 228 may be set to a predetermined temperature increase. For instance, the supply cooling fluid temperature may be increased by around 1 to 5 or more degrees C. Alternatively, the level of increase may be based upon, for instance, the level at which the $RHI_i$ value exceed the $RHI_{SET}$ value. In this instance, the increase in supply cooling fluid temperature may substantially be proportional to the level at which the $RHI_i$ value exceeds the $RHI_{SET}$ value. In one respect, by increasing the temperature of the cooling fluid supplied by the CRAC unit 228 when the $RHI_i$ value exceeds the $RHI_{SET}$ value, the CRAC unit 228 generally consumes less energy.

Steps 706-710 may be repeated for any reasonable suitable amount of time. For instance, these steps may be repeated so long as the data center 100 is operational, for a predetermined period of time or iterations, etc. In addition, the operational mode 700 may end, for instance, based upon a user's discretion.

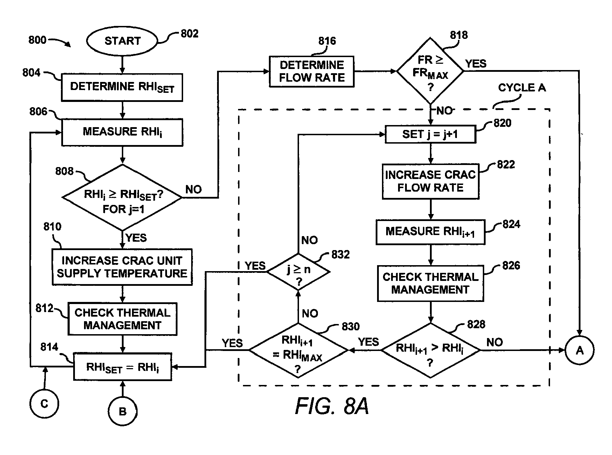

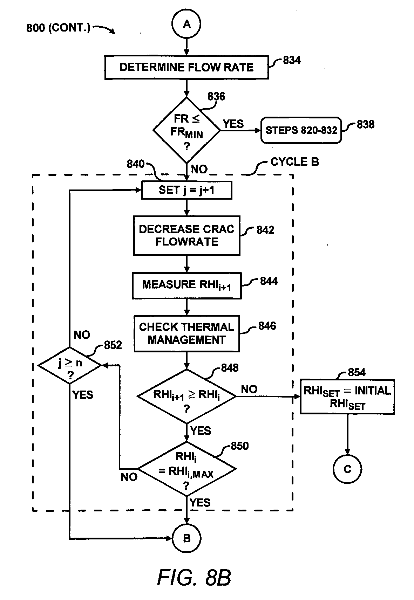

Additional steps that may be employed with the operational mode 700 are described with respect to FIGS. 8A and 8B below.

FIGS. 8A and 8B, collectively illustrate a flow diagram of an operational mode 800 for a cooling system, for instance, the cooling system 202, based substantially upon RHI values. It is to be understood that the following description of the operational mode 800 is but one manner of a variety of different manners in which the cooling system may be operated. It should also be apparent to those of ordinary skill in the art that the operational mode 800 represents a generalized illustration and that other steps may be added or existing steps may be removed or modified without departing from the scope of the invention. The description of the operational mode 800 is made with reference to the block diagram 200 illustrated in FIG. 2, and thus makes reference to the elements cited therein.

In one regard, the controller 204 may implement the operational mode 800 to control one or more CRAC units 228 based upon calculated RHI values. More particularly, for instance, the operational mode 800 may be implemented to control one or more of the CRAC units 228 such that their energy consumption levels are substantially minimized. In addition, one or more of the CRAC units 228 may be operated in manners to generally maintain beneficial thermal management levels. Although particular reference is made to a single CRAC unit 228, it should be understood that the concepts outlined with respect to the operational mode 800 may be applied to control any reasonably suitable number of CRAC units 228. Accordingly, the description of the operations of a single CRAC unit 228 is for simplicity of description purposes and is not meant to limit the operational mode 800 to a single CRAC unit 228.

The operational mode 800 may be initiated in response to a variety of stimuli at step 802. For example, the operational mode 800 may be initiated in response to a predetermined lapse of time, in response to receipt of a transmitted signal, and/or in response to a detected change in an environmental condition (for instance, temperature, humidity, location, etc.). In addition, a user may manually initiate the operational mode 800.

At step 804, an RHI setpoint ($RHI_{SET}$) may be determined as described hereinabove with respect to step 704 (FIG. 7). In addition, at step 806, the $RHI_i$ value for the CRAC unit 228 may be measured as described with respect to step 706 (FIG. 7).

At step 808, the $RHI_i$ value determined at step 806 is compared with the $RHI_{SET}$ value determined at step 804 for a value "j" equal to one (1). In one example, the value "j" may denote the number of iterations of the CRAC unit 228 flow rate variations. In other examples, the value "j" may denote various other criteria, such as, for instance, power consumed by the CRAC unit 228, maintenance recommendations, etc. In addition, the rate at which "j" is incremented may substantially be limited by hardware and control requirements. Further examples of the value "j" are provided hereinbelow.

If, at step 808, the $RHI_i$ value is greater than or equal to the $RHI_{SET}$ value, the temperature at which cooling fluid is supplied by the CRAC unit 228 is increased as indicated at step 810. The level of increase in the supply cooling fluid temperature of the CRAC unit 228 may be set to a predetermined temperature increase. For instance, the supply cooling fluid temperature may be increased by around 1 to 5 or more degrees C. Alternatively, the level of increase may be based upon, for instance, the level at which the $RHI_i$ value exceed the $RHI_{SET}$ value. In this instance, the increase in supply cooling fluid temperature may substantially be proportional to the level at which the $RHI_i$ value exceeds the $RHI_{SET}$ value. In one respect, by increasing the temperature of the cooling fluid supplied by the CRAC unit 228 when the $RHI_i$ value exceeds the $RHI_{SET}$ value, the CRAC unit 228 generally consumes less energy.

At step 812, the thermal management of the data center 100, 100 may be checked. By way of example, the SHI levels at various locations in areas affected by the CRAC unit 228 may be checked to determine whether the increased supply cooling fluid temperature has negatively impacted re-circulation levels. In addition or alternatively, the thermal management check may include monitoring the inlet temperatures of one or more of the racks to determine whether their temperatures are above a predetermined temperature level, for instance, around 25°C. Although not specifically illustrated, step 812 may also include steps to improve thermal management in the event that the check indicates that problems exist with thermal management. As an example, if the inlet temperatures of one or more of the racks are above the predetermined temperature level, the cooling airflow delivered to those one or more racks may be modified. For instance, the volume flow rate of the cooling airflow may be increased through manipulation of either or both ofassociated vent tiles 116 and CRAC units 228. As another example, if the SHI levels at various locations are above a maximum SHI setpoint, one or more of the steps outlined in FIGS. 4A and 4B may be performed to reduce the SHI levels at those areas.

Although not explicitly shown in FIG. 8A, a predetermined amount of time may be allowed to elapse between steps 810 and 812. The delay between steps 810 and 812 may be used to substantially enable the effects of the change in supply cooling fluid temperature to be detected. In one regard, the controller 204 may have access to a timer or a clock to determine when to perform step 812 following performance of step 810. The length of the delay may be based upon known lengths of time between cooling fluid temperature changes and their effects on various thermal management concerns. Alternatively, the length of the delay may be a preset amount of time, for instance, around 2, 5, 10 or more minutes.

At step 814, the $RHI_{SET}$ value is set to equal the $RHI_i$ value. This step is performed to, for instance, vary the conditions by which subsequently measured $RHI_i$ values are compared. In one respect, setting the $RHI_{SET}$ value to the $RHI_i$ value is performed to enable the operational mode 800 to be performed in a heuristic manner. In addition, the $RHI_i$ value for another iteration is measured again at step 806 and steps 808-814 may be repeated.

With reference back to step 808, if the $RHI_i$ value measured at step 806 is less than the $RHI_{SET}$ value determined at step 804, the flow rate at which cooling fluid is supplied by the CRAC unit 228 may be determined, at step 816. The flow rate of the cooling fluid supplied may be detected directly through use of an anemometer or it may be calculated based upon detection of the blower rotations. In any respect, the determined flow rate (FR) may be compared with a maximum flow rate set point ($FR_{MAX}$) at step 818. The maximum flow rate set point may indicate the highest desirable flow rate of cooling fluid supplied by the CRAC unit 228 and may be based upon, for instance, manufacturer specified blower operations, testing of the effects on cooling in the data center 100, 100 at various flow rates, etc.

If the determined flow rate is below the maximum flow rate set point, the value "j" may be set to j=j+1 at step 820. In addition, the flow rate at which cooling fluid is supplied by the CRAC unit 228 is increased as indicated at step 822. The level of increase in the cooling fluid flow rate supplied by the CRAC unit 228 may be set to a predetermined flow rate increase. For instance, the level of increase may be based upon, for instance, the level at which the $RHI_i$ value falls below the $RHI_{SET}$ value. In this instance, the increase in flow rate may substantially be proportional to the level at which the $RHI_i$ value falls below the $RHI_{SET}$ value. In one respect, the RHI level may be increased by increasing the flow rate of the cooling fluid supplied by the CRAC unit 228 when the $RHI_i$ value falls below the $RHI_{SET}$ value, thereby increasing the efficiency of the CRAC unit 228. As another example, the level of increase in flow rate may be based upon the difference between the flow rate (FR) and the maximum flow rate set point ($FR_{MAX}$). In this example, the increase in flow rate may substantially be equal to a proportion of the difference in flow rates. Alternatively, the increase may substantially be equal to an incremented value of the difference between the flow rates.

At step 824, the $RHI_i$ value may be measured again, which in this instance would yield an $RHI_{i+1}$ value. Although not explicitly shown in FIG. 8A, a predetermined amount of time may be allowed to elapse between steps 822 and 824. The delay between steps 822 and 824 may be used to enable the effects of the change in the cooling fluid flow rate to be detected. In one regard, the controller 204 may have access to a timer or a clock to determine when to perform step 824 following performance of step 822. The length of the delay may be based upon known lengths of time between cooling fluid flow rate changes and their effects on RHI measurements. Alternatively, the length of the delay may be a preset amount of time, for instance, around 2, 5, 10 or more minutes.

At step 826, the thermal management of the data center 100 may be checked. By way of example, the SHI levels at various locations in areas affected by the CRAC unit 228 may be checked to determine whether the increased supply cooling fluid temperature has negatively impacted re-circulation levels. In addition, the thermal management check at step 826 may be performed in manners as described hereinabove with respect to step 812.

At step 828, it is determined whether the $RHI_{i+1}$ value exceeds the $RHI_i$ value. In other words, it is determined whether the increase in flow rate of the CRAC unit 228 resulted in a higher RHI value. A higher RHI value may be indication that the increased flow rate resulted in a positive RHI measurement. If the $RHI_{i+1}$ value exceeds the $RHI_i$ value, it is determined whether the $RHI_{i+1}$ value has substantially reached a maximum RHI value ($RHI_{MAX}$) at step 830. If it is determined that $RHI_{i+1}$ has not substantially reached the maximum RHI value, it may be determined whether the number of iterations "j" meets or exceeds a value "n" as indicated at step 832.

As described hereinabove, the value "j" may, in certain instances, denote the number of iterations of the CRAC unit 228 flow rate variations. In other examples, the value "j" may denote various other criteria, such as, for instance, power consumed by the CRAC unit 228, maintenance recommendations, etc. In addition, the rate at which "j" is incremented may substantially be limited by hardware and control requirements. The value "n" may denote a predetermined number of iterations and may be set according to a number of various criteria. For instance, the number of iterations "n" may be selected relatively arbitrarily or it may be selected based upon testing. By way of example, the number of iterations "n" may be determined according to the difference between the flow rate (FR) and the maximum flow rate setpoint ($FR_{MAX}$) determined at step 818. The difference between these flow rates may be appropriately incremented and the number of increments may be used to set the number of iterations "n". Thus, for instance, if there are ten increments before the flow rate reaches the maximum flow rate set point, the number of iterations "n" may equal ten.

If the value "j" falls below the number of iterations "n", the value "j" may be incremented once as indicated at step 820. In addition, steps 822-832 may be repeated until either the $RHI_{i+1}$ equals the $RHI_{MAX}$ value as indicated above with respect to step 830 or the "j" value meets or exceeds the "n" value. If the value "j" meets or exceeds the value "n" at step 832, that is, for instance, the flow rate has reached or exceeds the maximum flow rate set point, or if the $RHI_{i+1}$ value has substantially reached the maximum RHI value, the $RHI_{SET}$ value is set to equal the $RHI_i$ value, as indicated at step 814. In addition, the $RHI_i$ value for another iteration is measured again at step 806 and steps 808-832 may be repeated. In this regard, for instance, if the RHI values are equal to or exceed a setpoint RHI value, the CRAC unit 228 supply temperature may be increased, thereby reducing the energy cost associated with operating the CRAC unit 228. In addition, if the RHI values fall below the setpoint RHI value, steps may be taken to increase RHI to thereby efficiency of the CRAC unit 228.

A determination as to whether the RHI value has reached the maximum RHI value may be made through an analysis of the changes to $RHI_{i+1}$ for various increases to CRAC unit 228 flow rate settings. For instance, it may be determined that the $RHI_{i+1}$ value has reached the maximum RHI value if, at step 828, the RHI value for a subsequent iteration equals or is less than the RHI value for a previous iteration.

If, however, at step 828 the $RHI_{i+1}$ value equals or falls below the $RHI_i$ value, which indicates that the increased flow rate did not result in a positive RHI measurement, Cycle B may be performed as described hereinbelow.

As shown in FIG. 8A, steps 820-832 are characterized as Cycle A, which includes steps to increase RHI through increase of the flow rate of air supplied by the CRAC unit 228. In contrast, Cycle B, shown in FIG. 8B, includes steps 840-852 to increase RHI through decrease of the flow rate of air supplied by the CRAC unit 228. Although Cycle A is illustrated and described as being performed prior to Cycle B, it should be appreciated that Cycle B may be performed prior to Cycle A without departing from a scope of the operational mode 800. Thus, with respect to FIG. 8B, the flow rate (FR) of air supplied by the CRAC unit 228 may be determined at step 834. In this regard, step 834 may be performed following step 808, in the instance that Cycle B is performed prior to Cycle A. Various manners in which the flow rate (FR) may be detected are described hereinabove with respect to step 816. Step 834, however, may be omitted in situations where Cycle B is performed following Cycle A and the flow rate is already known.

In any respect, at step 836, the flow rate (FR) may be compared with a minimum flow rate set point ($FR_{MIN}$) at step 836. The minimum flow rate set point may indicate the lowest desirable flow rate of cooling fluid supplied by the CRAC unit 228 and may be based upon, for instance, manufacturer specified blower operations, testing of the effects on cooling in the data center 100 at various flow rates, etc. If the flow rate (FR) is below or equal to the minimum flow rate set point ($FR_{MIN}$), steps 820-832 (FIG. 8A) may be performed as indicated at step 838 to increase the CRAC unit 228 flow rate.

If the flow rate (FR) is above the minimum flow rate set point ($FR_{MIN}$), the value "j" may be set to "j+1 at step 840. If Cycle B is performed following Cycle A, the value "j" may be reset such that the iterations performed in Cycle A are not included in the determination of iterations "j" in Cycle B. Otherwise, the value "j" may be set to "j+1 following step 808.

At step 842, the flow rate at which cooling fluid is supplied by the CRAC unit 228 is decreased. In addition, step 842 may be performed if the flow rate (FR) of cooling fluid supplied by the CRAC unit 228 equals or exceeds the maximum flow rate setpoint ($FR_{MAX}$) at step 818. The level of decrease in the cooling fluid flow rate supplied by the CRAC unit 228 may be set to a predetermined flow rate decrease. For instance, the level of decrease may be based upon, for instance, the level at which the $RHI_i$ value falls below the $RHI_{SET}$ value. In this instance, the decrease in flow rate may substantially be proportional to the level at which the $RHI_i$ value falls below the $RHI_{SET}$ value. In one respect, the RHI level may be increased by decreasing the flow rate of the cooling fluid supplied by the CRAC unit 228 when the $RHI_i$ value falls below the $RHI_{SET}$ value, thereby increasing the efficiency of the CRAC unit 228. As another example, the level of increase in flow rate may be based upon the difference between the flow rate (FR) and the minimum flow rate set point ($FR_{MIN}$). In this example, the decrease in flow rate may substantially be equal to a proportion of the difference in flow rates. Alternatively, the decrease may substantially be equal to an incremented value of the difference between the flow rates.

At step 844, the $RHI_i$ value may be measured again, which in this instance would yield an $RHI_{i+1}$ value. Although not explicitly shown in FIG. 8B, a predetermined amount of time may be allowed to elapse between steps 842 and 844. The delay between steps 842 and 844 may be used to enable the effects of the change in the cooling fluid flow rate to be detected. In one regard, the controller 204 may have access to a timer or a clock to determine when to perform step 844 following performance of step 842. The length of the delay may be based upon known lengths of time between cooling fluid flow rate changes and their effects on RHI measurements. Alternatively, the length ofthe delay may be a preset amount of time, for instance, around 2, 5, 10 or more minutes.

At step 846, the thermal management of the data center 100, 100 may be checked. The thermal management check at step 846 may be performed in manners as described hereinabove with respect to steps 812 and 826.

At step 848, it is determined whether the $RHI_{i+1}$ value exceeds the $RHI_i$ value. In other words, it is determined whether the decrease in flow rate of the CRAC unit 228resulted in a higher RHI value. A higher RHI value may be indication that the decreased flow rate resulted in a positive RHI measurement. If the $RHI_{i+1}$ value exceeds the $RHI_i$ value, it is determined whether the $RHI_{i+1}$ value has substantially reached a maximum RHI value ($RHI_{MAX}$) at step 850. If it is determined that $RHI_{i+1}$ has not substantially reached the maximum RHI value, it may be determined whether the number of iterations "j" meets or exceeds a value "n" as indicated at step 852.

As described hereinabove, the value "j" may, in certain instances, denote the number of iterations of the CRAC unit 228 flow rate variations. In other examples, the value "j" may denote various other criteria, such as, for instance, power consumed by the CRAC unit 228, maintenance recommendations, etc. In addition, the rate at which "j" is incremented may substantially be limited by hardware and control requirements. The value "n" may denote a predetermined number of iterations and may be set according to a number of various criteria. For instance, the number of iterations "n" may be selected relatively arbitrarily or it may be selected based upon testing. By way of example, the number of iterations "n" may be determined according to the difference between the flow rate (FR) and the minimum flow rate setpoint ($FR_{MIN}$) determined at step 836. The difference between these flow rates may be appropriately incremented and the number of increments may be used to set the number of iterations "n". Thus, for instance, if there are ten increments before the flow rate reaches the minimum flow rate set point, the number of iterations "n" may equal ten.

If the value "j" falls below the number of iterations "n", the value "j" may be incremented once as indicated at step 840. In addition, steps 842-852 may be repeated until either the $RHI_{i+1}$ equals the $RHI_{MAX}$ value as indicated above with respect to step 850 or the "j" value meets or exceeds the "n" value.

If the value "j" equals or exceeds the value "n" at step 852, or if the $RHI_{i+1}$ value has substantially reached the maximum RHI value, the $RHI_{SET}$ value is set to equal the $RHI_i$ value, as indicated at step 814, and as described in greater detail hereinabove with respect to step 830. In addition, the $RHI_i$ value for another iteration is measured again at step 806 and steps 808-850 may be repeated. In this regard, for instance, if the RHI values are equal to or exceed a setpoint RHI value, the CRAC unit 228 supply temperature may be increased, thereby reducing the energy cost associated with operating the CRAC unit 228. In addition, if the RHI values fall below the setpoint RHI value, steps may be taken to increase RHI to thereby efficiency of the CRAC unit 228.

If, however, at step 848 the $RHI_{i+1}$ value equals or falls below the $RHI_i$ value, which indicates that the decreased flow rate did not result in a positive RHI measurement, the $RHI_{SET}$ value may be set to equal the initial $RHI_{SET}$ value determined at step 804 and steps 806-852 may be repeated.

Although the operational mode 800 has been described with Cycle A being performed prior to Cycle B, it should be understood that the order in which some of the steps are performed in the operational mode 800 may be modified without departing from a scope of the invention. In this respect, and certain instances, Cycle B may be performed prior to Cycle A.

The operations illustrated in the operational modes 400, 450, 500, 600, 700 and 800 may be contained as a utility, program, or a subprogram, in any desired computer accessible medium. In addition, the operational modes and 400, 450, 500, 600, 700 and 800 may be embodied by a computer program, which can exist in a variety of forms both active and inactive. For example, they can exist as software program(s) comprised of program instructions in source code, object code, executable code or other formats. Any of the above can be embodied on a computer readable medium, which include storage devices and signals, in compressed or uncompressed form.

Exemplary computer readable storage devices include conventional computer system RAM, ROM, EPROM, EEPROM, and magnetic or optical disks or tapes. Exemplary computer readable signals, whether modulated using a carrier or not, are signals that a computer system hosting or running the computer program can be configured to access, including signals downloaded through the Internet or other networks. Concrete examples of the foregoing include distribution of the programs on a CD ROM or via Internet download. In a sense, the Internet itself, as an abstract entity, is a computer readable medium. The same is true of computer networks in general. It is therefore to be understood that any electronic device capable of executing the above-described functions may perform those functions enumerated above.

By virtue of certain embodiments of the present invention, the amount of energy, and thus the costs associated with maintaining environmental conditions within a data center within predetermined operating parameters, may be substantially reduced. In one respect, by operating the cooling system in manners that substantially increase RHI values, the cooling system may be operated at a relatively more efficient manner in comparison with conventional cooling systems.

What has been described and illustrated herein is a preferred embodiment of the invention along with some of its variations. The terms, descriptions and figures used herein are set forth by way of illustration only and are not meant as limitations. Those skilled in the art will recognize that many variations are possible within the scope of the invention, which is intended to be defined by the following claims -- and their equivalents -- in which all terms are meant in their broadest reasonable sense unless otherwise indicated.

**Claims**

1. A method (700, 800) for controlling a computer room air conditioning unit (228) based on an index of performance (RHI) designed to quantify re-circulation levels, said method (700, 800) comprising:

   determining (704, 804) an index of performance set point ($RHI_{set}$); **characterized in that** the method further comprises

   calculating (706, 806) the index of performance ($RHI_1$) for a first iteration, (i=1) by a controller (204), through the equation $RHI = 1 - (\dfrac{\sum_j \sum_i ((T^r_{in})_{i,j} - T_{ref})}{\sum_j \sum_i ((T^r_{out})_{i,j} - T_{ref})})$, wherein $(T^r_{in})_{i,j}$ and $(T^r_{out})_{i,j}$ are measured average inlet and outlet temperatures, respectively, from the $i^{th}$ rack in the $j^{th}$ row of racks, and $T_{ref}$ denotes the measured temperature of air supplied by one or more air conditioning unit (228);
   determining (708, 808) whether the calculated index of performance ($RHI_1$) for the first iteration equals or exceeds the index of performance set point ($RHI_{set}$); and
   increasing (710, 810) a supply air temperature of said one or more air conditioning unit (228) in response to the calculated index of performance ($RHI_1$) for the first iteration equaling or exceeding the index of performance set point ($RHI_{set}$).

2. The method (700, 800) according to claim 1, but wherein the step of calculating (706, 806) the index of performance ($RHI_1$) for the first iteration comprises solving the following equation:

   $RHI = \dfrac{\sum_k M_k C_p ((T^C_{in})_k - T_{ref})}{\sum_j \sum_i m^r_{i,j} C_p ((T^r_{out})_{i,j} - T_{ref})}$, wherein $M_k$ is a measured mass flow rate of cooling fluid through the kth air conditioning unit (228), Cp is the specific heat of air, $T^c_{in}$ is the individual air conditioning unit inlet temperature, $m^r_{i,j}$ is the mass flow rate through the $i th$ rack in the $j th$ row of racks and $(T^r_{in})_{i,j}$ and $(T^r_{out})_{i,j}$ are measured average inlet and outlet temperatures from the $i th$ rack in the jth row of racks, and $T_{ref}$ denotes the measured temperature of air supplied by said one or more air conditioning unit (228).

3. The method (800) according to any of claims 1 and 2, further comprising:

   determining (816) a flow rate (FR) of the air conditioning unit (228) in response to the calculated index of performance ($RHI_1$) for the first iteration falling below the index of performance set point ($RHI_{set}$);
   determining (818) whether the flow rate (FR) equals or exceeds a maximum flow rate set point ($FR_{max}$);
   increasing (822) the flow rate (FR) of air supplied by the air conditioning unit (228) in response to the determined flow rate (FR) falling below the maximum flow rate set point ($FR_{max}$);
   calculating (824) the index of performance ($RHI_2$) for a second iteration (i=2) in response to the increased flow rate (FR) of air supplied by the air conditioning unit (228);
   checking (826) thermal management in response to the step of increasing the flow rate (FR) of air supplied by the air conditioning unit (228);
   determining (828) whether the calculated index of performance ($RHI_2$) for the second iteration exceeds the calculated index of performance ($RHI_1$) for the first iteration;
   determining (830) whether the calculated index of performance ($RHI_2$) for the second iteration substantially equals a maximum index of performance ($RHI_{max}$) in response to the calculated index of performance ($RHI_2$) for the second iteration exceeding the calculated index of performance ($RHI_1$) for the first iteration;
   determining (832) whether a number of times (j) the flow rate (FR) of air supplied by the air conditioning unit (228) is increased equals or exceeds a predetermined number iterations (n) in response to the calculated index of performance ($RHI_2$) for the second iteration falling below the maximum index of performance ($RHI_{max}$) ; and

increasing (822) the flow rate (FR) of air supplied by the air conditioning unit (228) in response to the number of times (j) the flow rate (FR) of air supplied by the air conditioning unit (228) is increased falling below the predetermined number of iterations (n).

**4.** The method (800) according to claim 3, further comprising:

setting (814) the index of performance set point ($RHI_{set}$) to equal the calculated index of performance ($RHI_1$) for the first iteration in response to the index of performance ($RHI_2$) for the second iteration substantially equaling the maximum index of performance ($RHI_{max}$)

**5.** The method (800) according to claim 1, further comprising:

determining (834) a flow rate (FR) of the air conditioning unit (228) in response to the calculated index of performance ($RHI_1$) for the first iteration falling below the index of performance set point ($RHI_{set}$);
determining (836) whether the flow rate (FR) equals or falls below a minimum flow rate set point ($FR_{min}$);
decreasing (842) the flow rate of air (FR) supplied by the air conditioning unit in response to the flow rate (FR) exceeding the minimum flow rate set point ($FR_{min}$);
calculating (844) the index of performance ($RHI_2$) for a second iteration;
checking (846) thermal management;
determining (848) whether the calculated index of performance ($RHI_2$) for the second iteration exceeds the calculated index of performance ($RHI_1$) for the first iteration;
determining (850) whether the calculated index of performance ($RHI_2$) for the second iteration substantially equals a maximum index of performance ($RHI_{max}$) in response to the calculated index of performance ($RHI_2$) for the second iteration exceeding the measured index of performance ($RHI_1$) for the first iteration;
determining (852) whether a number of times (j) the flow rate of air (FR) supplied by the air conditioning unit (228) is decreased equals or exceeds a predetermined number of iterations (n) in response to the calculated index of performance ($RHI_2$) for the second iteration falling below the maximum index of performance ($RHI_{max}$);
decreasing (842) the flow rate (FR) of air supplied by the air conditioning unit (228) in response to the number of times (j) the flow rate of air (FR) supplied by the air conditioning unit (228) is decreased falling below the predetermined number of iterations (n); and
setting (814) the index of performance set point ($RHI_{set}$) to equal the calculated index of performance ($RHI_1$) for the first iteration in response to the number of times (j) the flow rate of air (FR) supplied by the air conditioning unit (228) is decreased equaling the predetermined number of iterations (n).

**6.** The method (800) according to claim 5, further comprising:

re-setting (854) the index of performance set point ($RHI_{set}$) to the determined index of performance set point ($RHI_{set}$) in response to the calculated index of performance ($RHI_2$) for the second iteration falling below the calculated index of performance ($RHI_1$) for the first iteration.

**7.** A system (202) for controlling a computer room air conditioning unit (228) based on an index of performance (RHI) designed to quantify re-circulation levels, said system (202) comprising:

a first temperature sensor (230) and a second temperature sensor (232); **characterized in that** the system (202) further comprises
a controller (204) configured to
calculate the index of performance (RHI) for a first iteration, (i=1) through the equation

$$RHI = 1 - \left( \frac{\sum_j \sum_i \left( (T_{in}^r)_{i,j} - T_{ref} \right)}{\sum_j \sum_i \left( (T_{out}^r)_{i,j} - T_{ref} \right)} \right),$$ wherein $(T^r_{in})_{i,j}$ and $(T^r_{out})_{i,j}$ are average inlet and outlet temperatures, respectively, from the *ith* rack in the *jth* row of racks measured by said sensors, and $T_{ref}$ denotes a measured temperature of air supplied by one or more air conditioning unit (228);
determine whether the calculated index of performance ($RHI_1$) for the first iteration equals or exceeds a predetermined index of performance set point ($RHI_{set}$); and
increase the supply air temperature of the air conditioning unit (228) in response to the calculated index of performance ($RHI_1$) for the first iteration equaling or exceeding the index of performance set point ($RHI_{set}$).

8. The system (202) according to claim 7, but wherein the controller (204) is further configured to calculate the index of performance (RHI$_1$) for the first iteration through the following equation:

$$RHI = \frac{\sum_k M_k C_p \left( \left( T_{in}^C \right)_k - T_{ref} \right)}{\sum_j \sum_i m_{i,j}^r C_p \left( \left( T_{out}^r \right)_{i,j} - T_{ref} \right)},$$ wherein $M_k$ is the mass flow rate of cooling fluid

through the $k^{th}$ air conditioning unit (228), Cp is the specific heat of air, $T^c_{in}$ is the individual air conditioning unit inlet temperature, $m^r_{i,j}$ is the mass flow rate through the *ith* rack in the *jth* row of racks and $(T^r_{in})_{i,j}$ and $(T^r_{out})_{i,j}$ are average inlet and outlet temperatures from the *ith* rack in the *jth* row of racks, and $T_{ref}$ denotes the temperature of air supplied by said one or more air conditioning unit (228).

9. A data center (100) having the system (202) of claim 7, said data center (100) comprising:

means for increasing (214) a supply air temperature of said one or more air conditioning unit (228) in response to the measured index of performance (RHI$_1$) for the first iteration equaling or exceeding the index of performance set point (RHI$_{set}$)

10. The data center (100) according to claim 9, further comprising:

means for variably receiving (166, 209) heated airflow from one or more locations in the data center (100); and means for directing (164) the received heated airflow to said one or more air conditioning unit (228).

**Patentansprüche**

1. Verfahren (700, 800) zur Steuerung einer Computerraum-Klimaanlageneinheit (228), auf der Grundlage eines Leistungsindexes (RHI), der entworfen ist, um die Niveaus der Rezirkulation zu quantifizieren, wobei das Verfahren (700, 800) Folgendes umfasst:

Bestimmung (704, 804) eines Leistungsindex-Einstellpunkts (RHI$_{set}$); **dadurch gekennzeichnet, dass** das Verfahren weiter Folgendes umfasst:

Berechnung (706, 806) des Leistungsindexes (RHI$_1$) für eine erste Wiederholung (i = 1) mit einem Regler (204) durch die folgende Gleichung:

$$RHI = 1 - \left( \frac{\sum_j \sum_i \left( \left( T_{in}^r \right)_{i,j} - T_{ref} \right)}{\sum_j \sum_i \left( \left( T_{out}^r \right)_{i,j} - T_{ref} \right)} \right)$$

wobei $(T^r_{in})_{i,j}$ und $(T^r_{out})_{i,j}$ gemessene durchschnittliche Einlass- bzw. Auslasstemperaturen vom *i-ten* Regal in der *j-ten* Reihe von Regalen sind, and $T_{ref}$ die gemessene Temperatur der Luft bezeichnet, die von einer oder von mehreren Klimaanlageneinheiten (228) bereitgestellt wird;
Bestimmung (708, 808), ob der berechnete Leistungsindex (RHI$_1$) für die erste Wiederholung dem Leistungsindex-Einstellpunkt (RHI$_{set}$) gleichkommt oder ihn übertrifft; und
Erhöhung (710, 810) einer Versorgungslufttemperatur der einen oder der mehreren Klimaanlageneinheiten (228) in Antwort auf den berechneten Leistungsindex (RHI$_1$) für die erste Wiederholung, die dem Leistungsindex-Einstellpunkt (RHI$_{set}$) gleichkommt oder ihn übertrifft.

2. Verfahren (700, 800) nach Anspruch 1, worin jedoch der Schritt des Berechnens (706, 806) des Leistungsindexes (RHI$_1$) für die erste Wiederholung die Lösung der folgenden Gleichung umfasst:

$$RHI = \frac{\sum\limits_{k} M_k C_p \left( \left( T_{in}^c \right)_k - T_{ref} \right)}{\sum\limits_{j} \sum\limits_{i} m_{i,j}^r C_p \left( \left( T_{out}^r \right)_{i,j} - T_{ref} \right)}$$

wobei $M_k$ eine gemessene Massendurchflussrate von Kühlfluid durch die *k-te* Klimaanlageneinheit (228) ist, Cp die spezifische Wärme der Luft ist, $T_{in}^c$ die individuelle Einlasstemperatur der Klimaanlageneinheit ist, $m_{ij}^r$ die Massendurchflussrate durch das *i-te* Regal in der *j-ten* Reihe von Regalen ist und $(T_{in}^r)_{i,j}$ und $(T_{out}^r)_{i,j}$ gemessene durchschnittliche Einlass- und Auslass-Temperaturen vom *i-ten* Regal in der *j-ten* Reihe von Regalen sind, und $T_{ref}$ die gemessene Temperatur der Luft bezeichnet, die durch die eine oder die mehreren Klimaanlageneinheiten (228) bereitgestellt wird.

3. Verfahren (800) nach einem der Ansprüche 1 und 2, weiter umfassend:

Bestimmung (816) einer Durchflussrate (FR) der Klimaanlageneinheit (228) in Antwort auf den berechneten Leistungsindex ($RHI_1$) für die erste Wiederholung, die unter den Leistungsindex-Einstellpunkt ($RHI_{set}$) fällt,
Bestimmung (818), ob die Durchflussrate (FR) einem maximalen Durchflussraten-Einstellpunkt ($FR_{max}$) gleichkommt oder ihn übertrifft;
Erhöhung (822) der Durchflussrate (FR) von Luft, die von der Klimaanlageneinheit (228) bereitgestellt wird, in Antwort auf die bestimmte Durchflussrate (FR), die unter den maximalen Durchflussraten-Einstellpunkt ($Fr_{max}$) fällt;
Berechnung (824) des Leistungsindexes ($RHI_2$) für eine zweite Wiederholung (i = 2) in Antwort auf die erhöhte Durchflussrate (FR) von Luft, die von der Klimaanlageneinheit (228) bereitgestellt wird;
Überprüfung (826) der Wärmeverwaltung in Antwort auf den Schritt des Erhöhens der Durchflussrate (FR) von Luft, die von der Klimaanlageneinheit (228) bereitgestellt wird;
Bestimmung (828), ob der berechnete Leistungsindex ($RHI_2$) für die zweite Wiederholung den berechneten Leistungsindex ($RHI_1$) für die erste Wiederholung übersteigt;
Bestimmung (830), ob der berechnete Leistungsindex ($RHI_2$) für die zweite Wiederholung im Wesentlichen einem maximalen Leistungsindex ($RHI_{max}$) gleichkommt in Antwort auf den berechneten Leistungsindex ($RHI_2$) für die zweite Wiederholung, der den berechneten Leistungsindex ($RHI_1$) für die erste Wiederholung übersteigt;
Bestimmung (832), ob eine Anzahl von Zeiten (j), in denen die Durchflussrate (FR) von Luft, die von der Klimaanlageneinheit (228) bereitgestellt wird, erhöht wird, einer vorbestimmten Anzahl von Wiederholungen (n) gleichkommt oder diese übersteigt in Antwort auf den berechneten Leistungsindex ($RHI_2$) für die zweite Wiederholung, die unter den maximalen Leistungsindex ($RHI_{max}$) fällt; und
Erhöhung (822) der Durchflussrate (FR) von Luft, die von der Klimaanlageneinheit (228) bereitgestellt wird, in Antwort auf die Anzahl von Zeiten (j), in denen die Durchflussrate (FR) von Luft, die von der Klimaanlageneinheit (228) bereitgestellt wird, erhöht wird, die unter die vorbestimmte Anzahl von Wiederholungen (n) fällt.

4. Verfahren (800) nach Anspruch 3, weiter umfassend:

Einstellung (814) des Leistungsindex-Einstellpunkts ($RHI_{set}$), um dem berechneten Leistungsindex ($RHI_1$) für die erste Wiederholung gleichzukommen in Antwort auf den Leistungsindex ($RHI_2$) für die zweite Wiederholung, die im Wesentlichen dem maximalen Leistungsindex ($RHI_{max}$) gleichkommt;

5. Verfahren (800) nach Anspruch 1, weiter umfassend:

Bestimmung (834) einer Durchflussrate (FR) der Klimaanlageneinheit (228) in Antwort auf den berechneten Leistungsindex ($RHI_1$) für die erste Wiederholung, die unter den Leistungsindex-Einstellpunkt ($RHI_{set}$) fällt;
Bestimmung (836), ob die Durchflussrate (FR) einem minimalen Durchflussraten-Einstellpunkt ($FR_{min}$) gleichkommt oder unter diesen fällt;
Verringerung (842) der Durchflussrate (FR) von Luft, die durch die Klimaanlageneinheit bereitgestellt wird, in Antwort auf die Durchflussrate (FR), die den minimalen Durchflussraten-Einstellpunkt ($FRI_{min}$) übersteigt;
Berechnung (844) des Leistungsindexes ($RHI_2$) für eine zweite Wiederholung;
Überprüfung (846) der Wärmeverwaltung;
Bestimmung (848), ob der berechnete Leistungsindex ($RHI_2$) für die zweite Wiederholung den berechneten

Leistungsindex (RHI$_1$) für die erste Wiederholung übersteigt;

Bestimmung (850), ob der berechnete Leistungsindex (RHI$_2$) für die zweite Wiederholung im Wesentlichen einem maximalen Leistungsindex (RHI$_{max}$) gleichkommt in Antwort auf den berechneten Leistungsindex (RHI$_2$) für die zweite Wiederholung, der den berechneten Leistungsindex (RHI$_1$) für die erste Wiederholung übersteigt;

Bestimmung (852), ob eine Anzahl von Zeiten (j), in denen die Durchflussrate (FR) von Luft, die von der Klimaanlageneinheit (228) bereitgestellt wird, verringert wird, einer vorbestimmten Anzahl von Wiederholungen (n) gleichkommt oder diese übersteigt in Antwort auf den berechneten Leistungsindex (RHI$_2$) für die zweite Wiederholung, die unter den maximalen Leistungsindex (RHI$_{max}$) fällt; und

Verringerung (842) der Durchflussrate (FR) von Luft, die von der Klimaanlageneinheit (228) bereitgestellt wird, in Antwort auf die Anzahl von Zeiten (j), in denen die Durchflussrate (FR) von Luft, die von der Klimaanlageneinheit (228) bereitgestellt wird, verringert wird, und unter die vorbestimmte Anzahl von Wiederholungen (n) fällt.

Einstellung (814) des Leistungsindex-Einstellpunkts (RHI$_{set}$), um dem berechneten Leistungsindex (RHI$_1$) für die erste Wiederholung gleichzukommen in Antwort auf die Anzahl von Zeiten (j), in denen die Durchflussrate von Luft (FR), die von der Klimaanlageneinheit (228) bereitgestellt wird, verringert wird, die der vorbestimmten Anzahl von Wiederholungen (n) gleichkommt.

6. Verfahren (800) nach Anspruch 5, weiter umfassend:

Wiedereinstellung (854) des Leistungsindex-Einstellpunkts (RHI$_{set}$) auf den festgesetzten Leistungsindex-Einstellpunkt (RHI$_{set}$) in Antwort auf den berechneten Leistungsindex (RHI$_2$) für die zweite Wiederholung, die unter den berechneten Leistungsindex (RHI$_1$) für die erste Wiederholung fällt.

7. System (202) zur Steuerung einer Computerraum-Klimaanlageneinheit (228) auf der Grundlage eines Leistungsindexes (RHI), der entworfen ist, um die Niveaus der Rezirkulation zu quantifizieren, wobei das System (202) Folgendes umfasst:

einen ersten Temperatursensor (230) und einen zweiten Temperatursensor (232); **dadurch gekennzeichnet, dass** das System (201) weiter Folgendes umfasst:

einen Regler (204), der konfiguriert ist, um

den Leistungsindex (RHI) für eine erste Wiederholung (i = 1) durch die folgende Gleichung zu berechnen:

$$RHI = 1 - \left( \frac{\sum_j \sum_i \left( \left( T_{in}^r \right)_{i,j} - T_{ref} \right)}{\sum_j \sum_i \left( \left( T_{out}^r \right)_{i,j} - T_{ref} \right)} \right)$$

wobei $(T^r_{in})_{i,j}$ und $(T^r_{out})_{i,j}$ durchschnittliche Einlass- bzw. Auslasstemperaturen vom *i-ten* Regal in der *j-ten* Reihe von Regalen sind, gemessen durch die Sensoren, und $T_{ref}$ eine gemessene Temperatur von Luft bezeichnet, die durch eine oder mehrere Klimaanlageneinheiten (228) bereitgestellt wird;

zu bestimmen, ob der berechnete Leistungsindex (RHI$_1$) für die erste Wiederholung einem vorbestimmten Leistungsindex-Einstellpunkt (RHI$_{set}$) gleichkommt oder diesen übertrifft; und

die Versorgungslufttemperatur der Klimaanlageneinheit (228) zu erhöhen in Antwort auf den berechneten Leistungsindex (RHI$_1$) für die erste Wiederholung, die dem Leistungsindex-Einstellpunkt (RHI$_{set}$) gleichkommt oder ihn übertrifft.

8. System (202) nach Anspruch 7, wobei jedoch der Regler (204) weiter konfiguriert ist, um den Leistungsindex (RHi$_1$) für die erste Wiederholung durch die folgende Gleichung zu berechnen:

$$RHI = \frac{\sum_{k} M_k C_p \left( \left( T_{in}^{c} \right)_k - T_{ref} \right)}{\sum_{j} \sum_{i} m_{i,j}^{r} C_p \left( \left( T_{out}^{r} \right)_{i,j} - T_{ref} \right)}$$

wobei $M_k$ die gemessene Massendurchflussrate von Kühlfluid durch die *k-te* Klimaanlageneinheit (228) ist, Cp die spezifische Wärme der Luft ist, $T^c{}_{in}$ die individuelle Einlasstemperatur der Klimaanlageneinheit ist, $m^r{}_{i,j}$ die Massendurchflussrate durch das *i-te* Regal in der *j-ten* Reihe von Regalen ist und $(T^r{}_{in})_{i,j}$ und $(T^r{}_{out})_{i,j}$ durchschnittliche Einlass- und Auslasstemperaturen vom *i-ten* Regal in der *j-ten* Reihe von Regalen sind, und $T_{ref}$ die Temperatur der Luft bezeichnet, die durch die eine oder die mehreren Klimaanlageneinheiten (228) bereitgestellt wird.

9. Datenzentrum (100) mit dem System (202) von Anspruch 7, wobei das Datenzentrum (100) Folgendes umfasst:

Mittel zur Erhöhung (214) einer Versorgungslufttemperatur der einen oder der mehreren Klimaanlageneinheiten (228) in Antwort auf den gemessenen Leistungsindex (RHI$_1$) für die erste Wiederholung, die dem Leistungsindex-Einstellpunkt (RHI$_{set}$) gleichkommt oder ihn übertrifft.

10. Datenzentrum (100) nach Anspruch 9, weiter umfassend:

Mittel, um variabel einen erwärmten Luftfluss aus einer oder mehreren Stellen im Datenzentrum (100) zu erhalten (166, 209); und
Mittel, um den empfangenen erwärmten Luftfluss an die eine oder die mehreren Klimaanlageneinheiten (228) zu richten (164).

**Revendications**

1. Procédé (700, 800) pour commander une unité de conditionnement d'air de salle machine (228) sur la base d'un indice de performance (RHI) conçu pour quantifier des niveaux de recirculation, ledit procédé (700, 800) comprenant les étapes consistant à :

- déterminer (704, 804) un point de consigne d'indice de performance (RHI$_{consigne}$) ; **caractérisé par le fait que** le procédé comprend en outre les étapes consistant à :
- calculer (706, 806) l'indice de performance (RHI$_1$) pour une première itération (1=1) par un contrôleur (204), par l'équation :

$$RHI = 1 - \left( \frac{\sum_{j} \sum_{i} \left( \left( T_{in}^{r} \right)_{i,j} - T_{ref} \right)}{\sum_{j} \sum_{i} \left( \left( T_{out}^{r} \right)_{i,j} - T_{ref} \right)} \right),$$

où $(T^r{}_{in})_{i,j}$ et $(T^r{}_{out})_{i,j}$ sont des températures d'entrée et de sortie moyennes mesurées, respectivement, à partir de la $i^{ème}$ baie dans la $j^{éme}$ rangée de baies, et $T_{réf}$ désigne la température d'air fourni par une ou plusieurs unités de conditionnement d'air (228) ;
- déterminer (708, 808) si l'indice de performance (RHI$_1$) calculé pour la première itération est égale ou supérieur à point de consigne d'indice de performance (RHI$_{consigne}$) ; et
- augmenter (710, 810) une température d'air fourni de ladite ou desdites unités de conditionnement d'air (228) en réponse au fait que l'indice de performance (RHI$_1$) calculé pour la première itération est égale ou supérieur au point de consigne d'indice de performance (RHI$_{consigne}$).

2. Procédé (700, 800) selon la revendication 1, mais dans lequel l'étape de calcul (706, 806) de l'indice de performance (RHI$_1$) pour la première itération comprend la résolution de l'équation suivante :

$$RHI = \frac{\sum_k M_k C_p \left( \left( T_{in}^c \right)_k - T_{ref} \right)}{\sum_j \sum_i m_{i,j}^r C_p \left( \left( T_{out}^r \right)_{i,j} - T_{ref} \right)},$$

où $M_K$ est un débit massique mesuré de fluide de refroidissement à travers la $k^{ème}$ unité de conditionnement d'air (228), Cp est la chaleur spécifique de l'air, $T^c{}_{in}$ est la température d'entrée d'unité de conditionnement d'air individuelle, $m^r{}_{i,j}$ est le débit massique à travers la $i^{ème}$ baie dans la $j^{ème}$ rangée de baies et $(T^r{}_{in})_{i,j}$ et $(T^r{}_{out})_{i,j}$ sont les températures d'entrée et de sortie moyennes mesurées pour la $i^{ème}$ baie dans la $j^{ème}$ de rangée de baies, et $T_{réf}$ désigne la température mesurée d'air fourni par ladite ou lesdites unités de conditionnement d'air (228).

3. Procédé (800) selon l'une quelconque des revendications 1 et 2, comprenant en outre les étapes consistant à :

- déterminer (816) un débit (FR) de l'unité de conditionnement d'air (228) en réponse au fait que l'indice de performance ($RHI_1$) calculé pour la première itération tombe sous le point de consigne d'indice de performance ($RHI_{consigne}$) ;
- déterminer (818) si le débit (FR) est égale ou supérieur à un point de consigne de débit maximal ($FR_{max}$) ;
- augmenter (822) le débit (FR) d'air fourni par l'unité de conditionnement d'air (228) en réponse au fait que le débit déterminé (FR) tombe sous le point de consigne de débit maximal ($FR_{max}$) ;
- calculer (824) l'indice de performance ($RHI_2$) pour une deuxième itération (i=2) en réponse au débit augmenté (FR) d'air fourni par l'unité de conditionnement d'air (228) ;
- contrôler (826) la gestion thermique en réponse à l'étape consistant à augmenter le débit (FR) d'air fourni par l'unité de conditionnement d'air (228) ;
- déterminer (828) si l'indice de performance ($RHI_2$) calculé pour la deuxième itération dépasse l'indice de performance ($RHI_1$) calculé pour la première itération ;
- déterminer (830) si l'indice de performance ($RHI_2$) calculé pour la deuxième itération est sensiblement égale à un indice de performance maximal ($RHI_{max}$) en réponse au fait que l'indice de performance ($RHI_2$) calculé pour la deuxième itération dépasse l'indice de performance ($RHI_1$) calculé pour la première itération ;
- déterminer (832) si un nombre de fois (j) où le débit (FR) d'air fourni par l'unité de conditionnement d'air (228) est augmenté est égale ou supérieur à un nombre prédéterminé d'itérations (n) en réponse au fait que l'indice de performance ($RHI_2$) calculé pour la deuxième itération tombe sous l'indice de performance maximal ($RHI_{max}$) ; et
- augmenter (822) le débit (FR) d'air fourni par l'unité de conditionnement d'air (228) en réponse au fait que le nombre de fois (j) où le débit (FR) d'air fourni par l'unité de conditionnement d'air (228) est augmenté tombe sous le nombre d'itérations prédéterminé (n).

4. Procédé (800) selon la revendication 3, comprenant en outre :

- le réglage (814) du point de consigne d'indice de performance ($RHI_{consigne}$) pour être égale à l'indice de performance ($RHI_1$) calculé pour la première itération en réponse au fait que l'indice de performance ($RHI_2$) pour la deuxième itération est sensiblement égale à l'indice de performance maximal ($RHI_{max}$).

5. Procédé (800) selon la revendication 1, comprenant en outre les étapes consistant à :

- déterminer (834) un débit (FR) de l'unité de conditionnement d'air (228) en réponse au fait que l'indice de performance ($RHI_1$) calculé pour la première itération tombe sous le point de consigne d'indice de performance ($RHI_{consigne}$) ;
- déterminer (836) si le débit (FR) est égale ou inférieur à un point de consigne de débit minimal ($FR_{min}$) ;
- diminuer (842) le débit d'air (FR) fourni par l'unité de conditionnement d'air en réponse au fait que le débit (FR) dépasse le point de consigne de débit minimal ($FR_{min}$) ;
- calculer (844) l'indice de performance ($RHI_2$) pour une deuxième itération ;
- contrôler (846) une gestion thermique ;
- déterminer (848) si l'indice de performance ($RHI_2$) calculé pour la deuxième itération dépasse l'indice de performance ($RHI_1$) calculé pour la première itération ;
- déterminer (850) si l'indice de performance ($RHI_2$) calculé pour la deuxième itération est sensiblement égale à un indice de performance maximal ($RHI_{max}$) en réponse au fait que l'indice de performance ($RHI_2$) calculé

pour la deuxième itération dépasse l'indice de performance (RHI$_1$) mesuré pour la première itération ;
- déterminer (852) si un nombre de fois (j) où le débit d'air (FR) fourni par l'unité de conditionnement d'air (228) est diminué est égale ou supérieur à un nombre d'itérations prédéterminé (n) en réponse au fait que l'indice de performance (RHI$_2$) calculé pour la deuxième itération tombe sous l'indice de performance maximal (RHI$_{max}$) ;
- diminuer (842) le débit (FR) d'air fourni par l'unité de conditionnement d'air (228) en réponse au fait que le nombre de fois (j) où le débit (FR) d'air fourni par l'unité de conditionnement d'air (228) est diminué tombe sous le nombre d'itérations prédéterminé (n) ; et
- régler (814) le point de consigne d'indice de performance (RHI$_{consigne}$) pour être égale à l'indice de performance (RHI$_1$) calculé pour la première itération en réponse au fait que le nombre de fois (j) où le débit d'air (FR) fourni par l'unité de conditionnement d'air (228) est diminué est égale au nombre d'itérations prédéterminé (n).

6. Procédé (800) selon la revendication 5, comprenant en outre :

- le re-réglage (854) du point de consigne d'indice de performance (RHI$_{consigne}$) au point de consigne d'indice de performance déterminé (RHI$_{consigne}$) en réponse au fait que l'indice de performance (RHI$_2$) calculé pour la deuxième itération tombe sous l'indice de performance (RHI$_1$) calculé pour la première itération.

7. Système (202) pour commander une unité de conditionnement d'air (228) pour salle machine sur la base d'un indice de performance (RHI) conçu pour quantifier des niveaux de recirculation, ledit système (202) comprenant :

- un premier capteur de température (230) et un second capteur de température (232) ; **caractérisé par le fait que** le système (202) comprend en outre :
- un contrôleur (204) configuré pour :

calculer l'indice de performance (RHI) pour une première itération (i=1), par l'équation :

$$RHI = 1 - \left( \frac{\sum_{j} \sum_{i} \left( (T_{in}^r)_{i,j} - T_{ref} \right)}{\sum_{j} \sum_{i} \left( (T_{out}^r)_{i,j} - T_{ref} \right)} \right),$$

où $(T_{in}^r)_{i,j}$ et $(T_{out}^r)_{i,j}$ sont les températures d'entrée et de sortie moyennes, respectivement, de la i$^{ème}$ baie dans la j$^{ème}$ rangée de baies mesurées par lesdits capteurs, et $T_{réf}$ désigne une température mesurée d'air fourni par une ou plusieurs unités de conditionnement d'air (228) ;
déterminer si l'indice de performance (RHI$_1$) calculé pour la première itération est égale ou supérieur à un point de consigne d'indice de performance prédéterminé (RHI$_{consigne}$) ; et
augmenter la température d'air fourni de l'unité de conditionnement d'air (228) en réponse au fait que l'indice de performance (RHI$_1$) calculé pour la première itération est égale ou supérieur au point de consigne d'indice de performance (RHI$_{consigne}$).

8. Système (202) selon la revendication 7, mais dans lequel le contrôleur (204) est en outre configuré pour calculer l'indice de performance (RHI$_1$) pour la première itération par l'équation suivante :

$$RHI = \frac{\sum_{k} M_k C_p \left( (T_{in}^c)_k - T_{ref} \right)}{\sum_{j} \sum_{i} m_{i,j}^r C_p \left( (T_{out}^r)_{i,j} - T_{ref} \right)},$$

où $M_k$ est le débit massique de fluide de refroidissement à travers la k$^{ème}$ unité de conditionnement d'air (228), Cp est la chaleur spécifique de l'air, $T_{in}^c$ est la température d'entrée d'unité de conditionnement d'air individuelle, $m_{i,j}^r$ est le débit massique à travers la i$^{ème}$ baie dans la j$^{ème}$ rangée de baies et $(T_{in}^r)_{i,j}$ et $(T_{out}^r)_{i,j}$ sont les températures d'entrée et de sortie moyennes de la i$^{ème}$ baie dans la j$^{ème}$ rangée de baies, et $(T_{réf})$ désigne la température d'air fourni par ladite ou lesdites unités de conditionnement d'air (228).

**9.** Centre de données (100) ayant le système (202) selon la revendication 7, ledit centre de données (100) comprenant :

- un moyen pour augmenter (214) une température d'air fourni de ladite ou desdites unités de conditionnement d'air (228) en réponse au fait que l'indice de performance ($RHI_1$) mesuré pour la première itération est égale ou supérieur au point de consigne d'indice de performance ($RHI_{consigne}$).

**10.** Centre de données (100) selon la revendication 9, comprenant en outre :

- un moyen de réception de manière variable (166, 209) d'un flux d'air chauffé à partir d'un ou plusieurs emplacements dans le centre de données (100) ; et
- un moyen pour diriger (164) le flux d'air chauffé reçu vers ladite ou lesdites unités de conditionnement d'air (228).

*FIG. 1A*

FIG. 1B

100

150    152

CRAC
UNIT
114

*FIG. 1C*

*FIG. 1D*

RETURN VENT TILE ACTUATOR(S) 209

RACK 1 ACTUATOR(S) 206a

RACK 2 ACTUATOR(S) 206b

VENT TILE ACTUATOR(S) 208a

HEU ACTUATOR(S) 208b

SERVERS 220

INTERFACE ELECTRONICS 210

BLOWER/VFD 244

COMPRESSOR 246

202

200

MEMORY 212

WORKLOAD MODULE 218

COOLING SYSTEM MODULE 214

RETURN TEMP SENSOR 238

SUPPLY TEMP SENSOR 240

CRAC UNIT 228

CONTROLLER 204

METRICS MODULE 216

RETURN TILE TEMP SENSOR 242

RACK 1
INLET TEMP SENSOR 230
OUTLET TEMP SENSOR 232
222

RACK 2
INLET TEMP SENSOR 234
OUTLET TEMP SENSOR 236
224

VENT TILE TEMP SENSOR 226

*FIG. 2*

*FIG. 3*

$400$ ⟶

**START/IDLE** — $402$

(B)

RECEIVE $(T_{in}^r)_{i,j}$ AND $(T_{out}^r)_{i,j}$ FOR ONE OR MORE RACKS (r) — $404$

RECEIVE $T_{ref}$ FROM ONE OR BOTH OF THE VENT TEMP SENSOR AND THE AIR CONDITIONING UNIT OUTLET TEMP SENSOR — $406$

INITIATE TIMER — $408$

CALCULATE $SHI_{i,j}$ AT TIME (t) — $410$

$414$

$412$
$SHI_{i,j}(t) \geq SHI_{max,set}$ ?
NO / YES

MANIPULATE ACTUATOR TO INCREASE AIRFLOW TO $RACK_{i,j}$

$418$
CALCULATE $SHI_{i,j}$ AT TIME (t + 1)

RECEIVE TEMPERATURES — $416$

$420$
$SHI_{i,j}(t) > SHI_{i,j}(t+1)$ ?
NO / YES

MANIPULATE ACTUATOR TO DECREASE AIRFLOW TO $RACK_{i,j}$ — $422$

(A)

*FIG. 4A*

A

← 450

RECEIVE $(T_{in}^r)_{i,j}$ AND $(T_{out}^r)_{i,j}$ FOR ONE OR MORE RACKS (r) ⎯ 452

RECEIVE $T_{ref}$ FROM ONE OR BOTH OF THE VENT TEMP SENSOR AND THE AIR CONDITIONING UNIT OUTLET TEMP SENSOR ⎯ 454

INITIATE TIMER ⎯ 456

CALCULATE $SHI_{i,j}$ AT TIME (t) ⎯ 458

462

NO ← SHI$_{i,j}$ (t) ≥ SHI max,set ? ⎯ 460 → YES → MANIPULATE ACTUATOR TO DECREASE AIRFLOW TO RACK$_{i,j}$

466

CALCULATE $SHI_{i,j}$ AT TIME (t + 1) ← RECEIVE TEMPERATURES ⎯ 464

NO ← SHI$_{i,j}$ (t) ≥ SHI$_{i,j}$ (t +1) ? ⎯ 468 → YES → MANIPULATE ACTUATOR TO INCREASE AIRFLOW TO RACK i,j ⎯ 470 → B

*FIG. 4B*

STEP 412

DETERMINE ACTUATOR SETTING(S) ⌐424

ACTUATOR SETTING(S) > PREDETERMINED MAXIMUM ACTUATOR SETTING(S) ? ⌐426

NO → STEP 414

YES

STEP 422

*FIG. 4C*

STEP 460

DETERMINE ACTUATOR SETTING(S) ⌐472

ACTUATOR SETTING(S) < PREDETERMINED MINIMUM ACTUATOR SETTING(S) ? ⌐474

NO → STEP 462

YES

STEP 470

*FIG. 4D*

500

```
┌─────────────────────────┐
│    RECEIVE WORKLOAD     │─── 502
│   PLACEMENT REQUEST     │
└─────────────────────────┘
             │
             ▼
┌─────────────────────────┐
│ IDENTIFY EQUIPMENT WITH EXCESS │─── 504
│ CAPACITY THAT MEETS SPECIFIED  │
│   PERFORMANCE POLICIES         │
└─────────────────────────┘
             │
             ▼
┌─────────────────────────┐
│    CALCULATE SHI FOR    │─── 506
│   IDENTIFIED EQUIPMENT  │
└─────────────────────────┘
             │
             ▼
┌─────────────────────────┐
│ PLACE WORKLOAD ON EQUIPMENT │─── 508
│   WITH LOWEST SHI VALUE     │
└─────────────────────────┘
```

## FIG. 5

600

```
┌─────────────────────────┐
│ CALCULATE SHI FOR A PROPOSED DATA │─── 602
│    CENTER CONFIGURATION           │
└─────────────────────────┘
             │
             ▼
┌─────────────────────────┐
│ RE-CONFIGURE THE PROPOSED DATA    │─── 604
│ CENTER CONFIGURATION TO MINIMIZE SHI │
└─────────────────────────┘
             │
             ▼
┌─────────────────────────┐
│ DEPLOY DATA CENTER WITH THE │─── 606
│  MINIMIZED SHI CONFIGURATION │
└─────────────────────────┘
```

## FIG. 6

700 →

START — 702

↓

DETERMINE $RHI_{SET}$ — 704

↓

MEASURE $RHI_i$ — 706

↓

DETERMINE WHETHER $RHI_i \geq RHI_{SET}$ — 708

↓

INCREASE CRAC UNIT SUPPLY TEMPERATURE IF $RHI_i \geq RHI_{SET}$ — 710

*FIG. 7*

FIG. 8A

800 (CONT.)

(A)

DETERMINE FLOW RATE — 834

836

FR ≤ FR$_{MIN}$ ? —— YES —— STEPS 820-832 — 838

840 — NO —— CYCLE B

SET j = j+1

DECREASE CRAC FLOWRATE — 842

MEASURE RHI$_{i+1}$ — 844

CHECK THERMAL MANAGEMENT — 846

848

NO — j ≥ n ? — 852

YES

RHI$_{i+1}$ ≥ RHI$_i$ ? —— NO —— RHI$_{SET}$ = INITIAL RHI$_{SET}$ — 854

YES

850

NO — RHI$_i$ = RHI$_{i,MAX}$ ?

YES

(B)

(C)

*FIG. 8B*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0741269 A2
- US 6574104 B
- US 30376102 A
- US 35142703 A
- US 6574104PATENT A
- US 425621 A
- US 10425624 A
- US 10425624 B
- US 62027203 A
- US 15789202 A
- US 21004002 A
- US 10210040 B
- US 26287902 A
- US 42562103 A
- US 37500303 A
- US 425624 A
- US 375003 A
- US 10345723 B

**Non-patent literature cited in the description**

- Dimensionless Parameters for Evaluation of Thermal Design and Performance of Large-Scale Data Centers. American Institute of Aeronautics and Astronautics, 24 June 2002
- Efficient Thermal Management of Data Centers - Immediate and Long-Term Research Needs. International Journal of Heat, Ventilating, Air-conditioning and Refrigeration Research. April 2003